# EUROPÄISCHE PATENTSCHRIFT

(11) **EP 0 647 355 B1**
(45) Veröffentlichungstag und Bekanntmachung des Hinweises auf die Patenterteilung: **05.09.2001**
(21) Anmeldenummer: 93912617.3
(22) Anmeldetag: 24.06.1993
(51) Int. Cl.: H01L 21/82, H01L 21/768, H01L 27/108

(54) **HERSTELLUNGSVERFAHREN FUR EINE HALBLEITERSPEICHERANORDNUNG**
PROCESS FOR PRODUCING A SEMICONDUCTOR STORAGE DEVICE
PROCEDE DE FABRICATION D'UNE MEMOIRE A SEMI-CONDUCTEURS

(30) Priorität: 30.06.1992 DE 4223878
(43) Veröffentlichungstag der Anmeldung: 12.04.1995
(73) Patentinhaber: Infineon Technologies AG, 81669 München (DE)
(72) Erfinder: AUER, Stefan, D-85221 Dachau (DE); KOHLHASE, Armin, D-85579 Neubiberg (DE); MELZNER, Hanno, D-82008 Unterhaching (DE)
(74) Vertreter: Zedlitz, Peter, Dipl.-Inf.
(86) Internationale Anmeldenummer: DE9300550
(87) Internationale Veröffentlichungsnummer: WO9400873

(56) Entgegenhaltungen:
- EP-A- 0 430 040
- EP-A- 0 457 131
- US-A- 5 061 650
- PATENT ABSTRACTS OF JAPAN vol. 16, no. 303 (E-1228) 3. Juli 1992 & JP,A,4 083 375 (TOSHIBA) 17. März 1992
- IEEE VMIC CONFERENCE Juni 1991, Seiten 144 - 152 CARTER W. KAANTA ET AL. 'DUAL DAMASCENE: A ULSI WIRING TECHNOLOGY' in der Anmeldung erwähnt
- PATENT ABSTRACTS OF JAPAN vol. 15, no. 3 (E-1019) 7. Januar 1991 & JP,A,2 257 671 (TOSHIBA) 18. Oktober 1990
- IBM TECHNICAL DISCLOSURE BULLETIN. Bd. 32, Nr. 9B, Februar 1990, NEW YORK US Seiten 378 - 381 'HIGH-DENSITY, FOLDED DRAM CELL'
- PATENT ABSTRACTS OF JAPAN vol. 14, no. 292 (E-944)(4235) 25. Juni 1990 & JP,A,2 094 558 (HITACHI) 5. April 1990
- PATENT ABSTRACTS OF JAPAN vol. 15, no. 408 (E-1123) 17. Oktober 1991 & JP,A,3 167 874 (SONY) 19. Juli 1991
- PATENT ABSTRACTS OF JAPAN vol. 11, no. 288 (E-542)(2735) 17. September 1987 & JP,A,62 086 853 (FUJITSU) 21. April 1987

## Beschreibung

Die Erfindung betrifft eine Halbleiterspeicheranordnung nach dem Oberbegriff des Patentanspruchs 1 und ein Herstellungsverfahren nach den Oberbegriffen der Patentansprüche 6 und 7, wie aus IBM Technical Disclosure Bulletin, Vol. 32, No. 9B, February 1990, pp. 378-381 bekannt.

DRAM-Halbleiterspeicher bestehen aus einer Anzahl von Speicherzellen in bzw. auf einem z. B. aus Silizium bestehenden Halbleitersubstrat, die sich jeweils aus einem Kondensator zur Speicherung der Information und einem Transistor zur Auswahl des bestimmten Kondensators zusammensetzt. Um eine geringe Zugriffszeit und benötigte Fläche bei hohem Speicherangebot zu erreichen, muß die Integrationsdichte der Anordnung erhöht werden, d. h. der Platzbedarf einer Zelle muß minimiert werden, gleichzeitig muß aber die elektrische Zuverlässigkeit gewährleistet bleiben. Ein Konzept für eine solche Speicherzelle ist die sogenannte "Stacked-Capacitor-above-Bitline"-Zelle, bei der der Kondensator oberhalb des Transistors und oberhalb der Bitleitung angeordnet ist (siehe beispielsweise S.Kimura et al., IEEE Trans. on ED, Vol. 37, No. 3, März 1990, S. 737) .

Dieses Zellkonzept hat den prinzipiellen Vorteil, daß die zur Verfügung stehende Zellfläche für den Kondensator optimal genutzt werden kann. Andererseits ergibt sich damit das Problem, den Kontakt vom Transistor zum Kondensator durch die Bitleitungsebene hindurch herzustellen. Bei dem für heutige DRAM's üblichen Verhältnissen von Bitleitungsraster und minimaler Strukturgröße ist es besonders vorteilhaft, wenn dieser Kontakt selbstjustiert zur Bitleitung hergestellt wird, d. h. der Isolationsabstand zwischen einem den Transistor mit der unteren Kondensatorelektrode verbindenden Kontaktpfeiler und der Bitleitung ist nicht lithographisch definiert, sondern ergibt sich durch eine geeignete Prozeßführung unabhängig vom lithographisch definierten Abstand.

Soweit solche Verfahren bereits bekannt sind, haben sie den Nachteil, daß die Waferoberfläche durch die spezifische Prozeßführung starke Unebenheiten aufweist, die die nachfolgenden Prozesse erschweren oder das Prozeßrisiko erhöhen. Insbesondere sind hier zu nennen:
- Erhöhung von Leitungswiderständen über unebenem Untergrund
- Gefahr von Leitungsunterbrechungen
- erschwerte Strukturierung über unebenem Untergrund, daher Gefahr von Kurzschlüssen und
- starker Abtrag des unterliegenden Materials durch lange Überätzung
- unterschiedliche Kontaktlochtiefe je nach Topographie
- Fokusprobleme bei der Lithographie.

Während einige dieser Probleme durch eine lokale Planarisierung entschärft oder gelöst werden, wie in der deutschen Patentanmeldung P 42 21 433 beschrieben, ist zur Lösung der Fokusprobleme eine globale Planarisierung vorteilhaft. In diesem Fall liegt die gesamte Waferoberfläche in einer, zur Substratoberfläche parallelen Ebene, die dann bei der Lithographie der Fokusebene der Abbildung entspricht.

Bei der hier behandelten DRAM-Schaltung treten besonders große Probleme auf bei der Herstellung des Kondensators auf unebenem Untergrund. Verwendet man einen "Schüsselkondensator", wie er z. B. in dem Artikel von T. Kaga in IEEE Trans. on ED, Vol. 38, No. 2, Febr. 91, S. 255 beschrieben ist, so ist ein hinreichend ebener Untergrund unerläßlich. Ferner treten durch die große Höhe des Kondensators besonders große Niveauunterschiede zwischen Zellenfeld und Peripherie auf, die die Herstellung der Verdrahtungsebenen aus den genannten Gründen erheblich erschweren.

In der JP-OS 4 083 375 ist eine DRAM-Zelle beschrieben, bei der der Kondensator als Stacked-capacitor oberhalb der Bitleitung angeordnet ist und zur Kapazitätserhöhung einen kammförmigen Querschnitt aufweist.

Eine derartige Speicherzelle und ein Herstellverfahren sind auch aus dem US-Patent 5 061 650 bekannt. Die nach oben weisenden Lamellen des Kondensators werden als Spacer durch Abscheidung von leitenden Schichten und anschließende anisotrope Ätzung hergestellt.

Diesen beiden HV ist gemeinsam, daß keine Planarisierungen vorgesehen sind, der Kondensator also auf einen Untergrund mit ausgeprägter Topologie hergestellt werden muß.

Ein weiteres HV für eine Stacked-capacitor-above-bitline-Zelle ist in IBM TDB Vol. 32, No 9B, Feb. 1990, S. 378-381 beschrieben .Die Integrationsdichte ist bei dieser Anordnung durch die spezielle Anordnung der Bitleitung und das notwendige sog. landing pad beim Anschluß des Kondensators begrenzt.

Aufgabe der vorliegenden Erfindung ist es daher, eine Halbleiterspeicheranordnung und ein Herstellverfahren für eine Halbleiterspeicheranordnung mit Speicherzellen des Stacked-Capacitors-above-Bitline-Typs anzugeben, welches bei der Herstellung bzgl. der Planarität verbesserte Oberflächen liefert.

Diese Aufgabe wird gelöst durch eine Speicheranordnung gemäß Patentanspruch 1 oder ein Herstellverfahren gemäß Patentanspruch 6 oder 7. Weiterbildungen, insbesondere Verfahren zur selbstjustierten Herstellung der Bitleitung zum Transistor-Kondensator-Kontaktpfeiler oder umgekehrt, sind Gegenstand von Unteransprüchen.

Die Erfindung beruht auf dem Einsatz eines Schleifverfahrens (sogenanntes Chemical mechanical polishing, CMP) als globales Planarisierungsverfahren. CMP kann bei verschiedenen Materialien eingesetzt werden und ist in den Artikeln von W.J. Patrick et al., in J. Electrochem. Soc., Vol. 138, No.6, Juni 91, S. 1778 sowie von C. Kaanta et al., VMIC Conference 1991, S. 144 beschrieben. Der Einsatz bei der Herstellung einer Halbleiterspeicheranordnung mit einem Stapelkondensator ist nicht bekannt.

CMP ermöglicht eine Planarisierung der Oberfläche mit folgenden Eigenschaften:
- Die Planarisierung ist lang reichweitig (einige bis einige 100 Mikrometer),
- die verbleibenden Stufen sind minimal (maximal ca.100nm),
- durch geeignete Zusammensetzung der Polierflüssigkeit kann eine Selektivität zwischen verschiedenen Materialien erzielt werden. Dies ermöglicht es beispielsweise, auf vergrabenen Schichten mit niedriger Abtragsrate zu stoppen.

Ein sinnvoller Einsatz eines CMP-Schrittes ist andererseits nur möglich, wenn die Oberfläche bereits vor dem Prozeß hinreichend gut planarisiert ist. Andernfalls würden hochliegende Strukturen beschädigt, während über tiefliegenden noch unerwünschte Reste verblieben. In der Praxis wird daher
- das CMP im Prozeßablauf wiederholt eingesetzt,
- das Schaltungsdesign auf diesen Randbedingungen abgestimmt, und
- jede unvermeidliche Unebenheit durch zusätzliche Planarisierungssequenzen ausgeglichen.

Die Erfindung ermöglicht einen Herstellprozeß für Stacked Capacitor-above-Bitline-Speicherzellen sowie für eine daraus aufgebaute Halbleiterspeicheranordnung, der diese mit dem Einsatz CMP grundsätzlich verbundenen Randbedingungen erfüllt.

Die Erfindung wird nachfolgend anhand der in den Zeichnungen dargestellten Ausführungsbeispiele näher beschrieben. Es zeigen:
- Figur 1:: einen Querschnitt durch eine Speicherzelle und durch einen Ausschnitt der Peripherie nach Durchführung des erfingungsgemäßen Verfahrens
- Figur 2:: eine Ausführungsform für das Layout der Speicherzellen in Aufsicht auf das Halbleitersubstrat
- Figuren 3 bis 32:: einen Querschnitt durch das Halbleitersubstrat im Zellenfeld, an dem die Verfahrensschritte von verschiedenen Ausführungsformen sowie Varianten für einige Verfahrensschritte verdeutlicht werden.

### Figur 1:

Es ist ein Querschnitt durch zwei benachbarte Speicherzellen, die einen gemeinsamen Transistor-Bitleitungs-Pfeiler (TB-Pfeiler) besitzen, parallel zum aktiven Gebiet und durch eine typische Peripherieschaltung darstellt, wobei die Speicheranordnung bis auf die Herstellung von Verdrahtungsebenen fertiggestellt ist. In einem Halbleitersubstrat 1 sind Isolationsgebiete 2 angeordnet, die verschiedene Speicherzellen voneinander isolieren, vorzugsweise werden sogenannte Trenchisolationsgebiete eingesetzt, deren Oberfläche auf gleicher Höhe wie die Substratoberfläche liegt. Das Halbleitersubstrat 1 enthält ferner dotierte Gebiete 3, 4, 5 als Source oder Drain (3, 4) von Transistoren im Zellenfeld Z oder in der Peripherie P oder als Anschluß (5) des Halbleitersubstrats 1. Auf der Substratoberfläche (bzw. auf einem nicht dargestellten Gateoxid) befinden sich in einer Wortleitungsebene ein Gate 6 des Transistors und andere leitende Stukturen 7. Ein Transistor-Kondensator-Pfeiler 9 (TK-Pfeiler verbindet das erste Source- bzw. Draingebiet (S/D-Gebiet) 3 des Transistors mit einer unteren Kondensatorelektrode 11, ein Transistor-Bitleitungs-Pfeiler 8 (TB-Pfeiler) verbindet das zweite S/D-Gebiet 4 mit einer überliegenden Bitleitung 10. In der Peripherie sind weitere Pfeiler vorgesehen, die in der Bitleitungsebene liegende Leitbahnen 12 mit dem dotierten Substratgebiet 5 (SB-Pfeiler 13) oder mit der leitenden Struktur 7 in der Wortleitung-Ebene (WB-Pfeiler 14) verbinden.

Die Pfeiler 8, 9, 13, 14, Bitleitung 10 und Leitbahnen 12 sind in einer ersten isolierenden Schicht 15 angeordnet, die auch eine Doppelschicht oder eine Doppelschicht mit darüberliegender Planarisierungsschicht sein kann. Die Pfeiler sind vorzugsweise selbstjustiert zum Gate 6 und/oder zur Trenchisolation 2 angeordnet, solche selbstjustierten Kontakte können beispielsweise nach den in dem Artikel von K. Küsters et al., J. de Physique, C4 No 9, Sept. 88, S-C4 503 beschriebenen Verfahren hergestellt werden.

Erfindungsgemäß sind alle in der Bitleitungs-Ebene liegenden Leitbahnen 12 und die Bitleitung 10 auf einen global planaren Untergrund angeordnet, die Oberkante der TB-, SB und WB-Pfeiler liegen - im Rahmen von Prozeßschwankungen auf gleicher Höhe. Die erste isolierende Schicht 15 bzw. die Planarisierungsschicht (15c) besitzt ebenfalls eine global planarisierte Oberfläche, die auf gleicher Höhe wie die Oberkante der TK-Pfeiler 9 liegt.

Der Kondensator besteht aus der unteren, vorzugsweise als Schüssel mit innenliegenden Lamellen ausgebildeten Kondensatorelektrode 11 und einer allen Speicherzellen gemeinsamen Gegenplatte 16, die durch ein Dielektrikum 47 von der unteren Kondensatorelektrode isoliert wird. Eine Weiterbildung der Erfindung sieht vor, daß die Oberkanten der unteren Kondensatorplatte 11 (d. h. des Schüsselrandes und der Lamellen) durch Einsatz eines CMP-Schrittes auf gleicher Höhe liegen, so daß die Oberkanten der unteren Kondensatorelektroden aller Speicherzellen des Halbleiterspeichers eine globale Planarisierung aufweisen.

Eine zweite isolierende Schicht 17 bedeckt die Gegenplatte 16 im Zellenfeld bzw. die erste isolierende Schicht 15 in der Peripherie. In ihr sind als Vias bezeichnete Kontaktlöcher 18, 19 angeordnet, über die die Gegenplatte 16 oder die Leitbahn 12 der Bitleitungs-Ebene (und damit das Halbleitersubstrat oder die Wortleitungs-Ebene) angeschlossen werden können. In einer Weiterbildung der Erfindung weist die zweite isolierende Schicht 17 eine global planarisierte Oberfläche auf. Dies ist besonders vorteilhaft bei der Ätzung der Vias 18 bzw. 19: Da die freizulegenden Strukturen (16 bzw. 12) auf global planarisierten Oberflächen angeordnet sind, bzw. selbst global planarisiert sind, sind die dabei zu durchätzenden Schichtdicken genau definiert. Eine geeignete ein- oder mehrlagige Metallisierungsstruktur (nicht dargestellt) dient anschließend zur niederohmigen Verdrahtung der Schaltelemente über die Vias 18, 19.

### Figur 2:

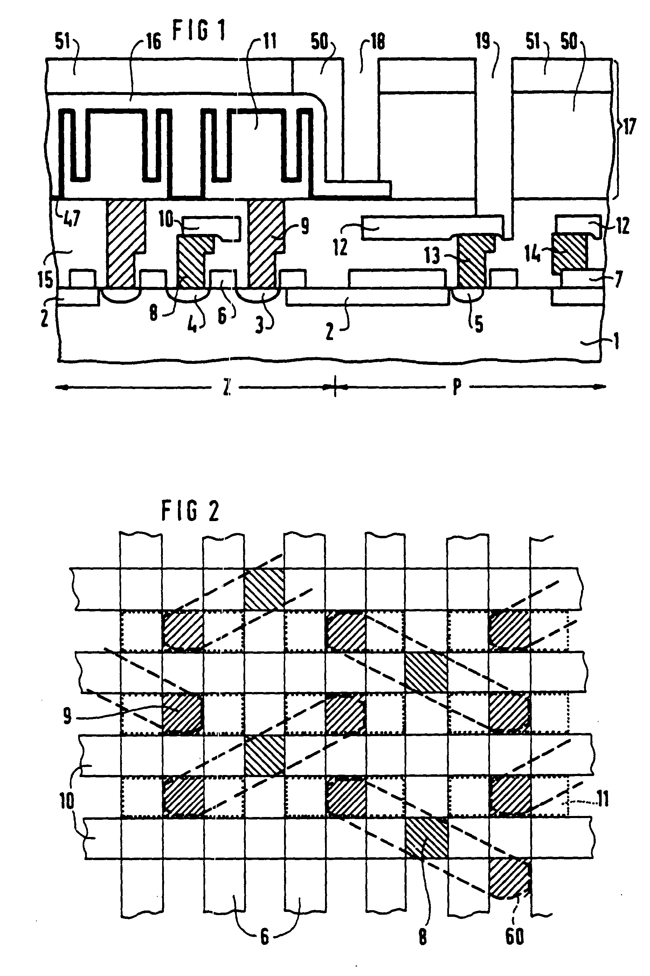

Eine Aufsicht auf ein mögliches Layout im Zellenfeld zeigt die Figur 2. Die Bitleitung 10 kann nicht - wie üblich parallel zum aktiven Gebiet 60 verlaufen, da sonst der Anschluß vom Transistor zum Kondensator durch die Bitleitung blockiert wird. Statt dessen muß die Bitleitung mit dem aktiven Gebiet einen Winkel einschließen. Dies kann u.a. durch Schrägstellen des aktiven Gebietes (Figur 2), durch Verschwenkung der Bitleitung oder beides oder ein "abgeknicktes" aktives Gebiet wie in dem bereits erwähnten Artikel von T. Kaga erfolgen.

Ähnliche Lösungen sind auch mit einem sogenannten "Quaterpitch Layout" möglich.

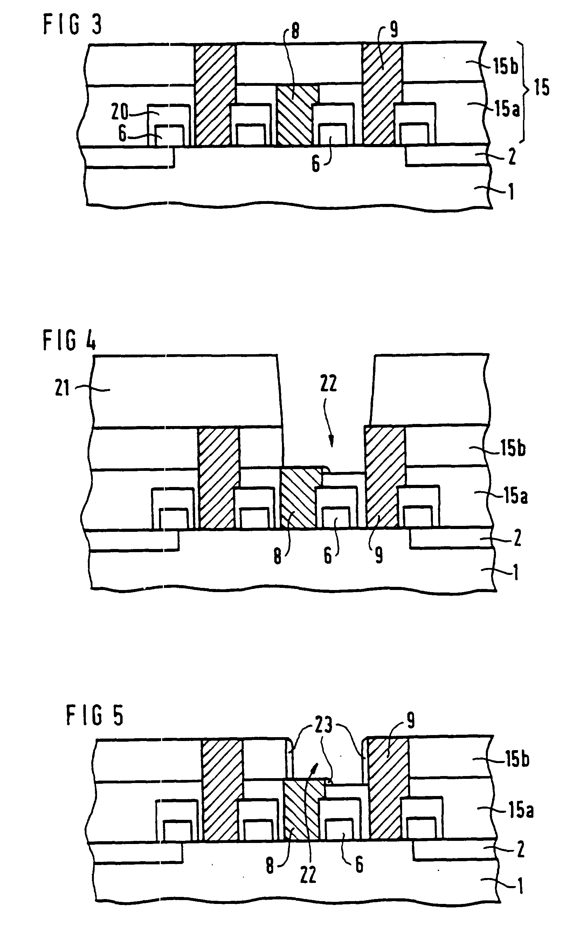

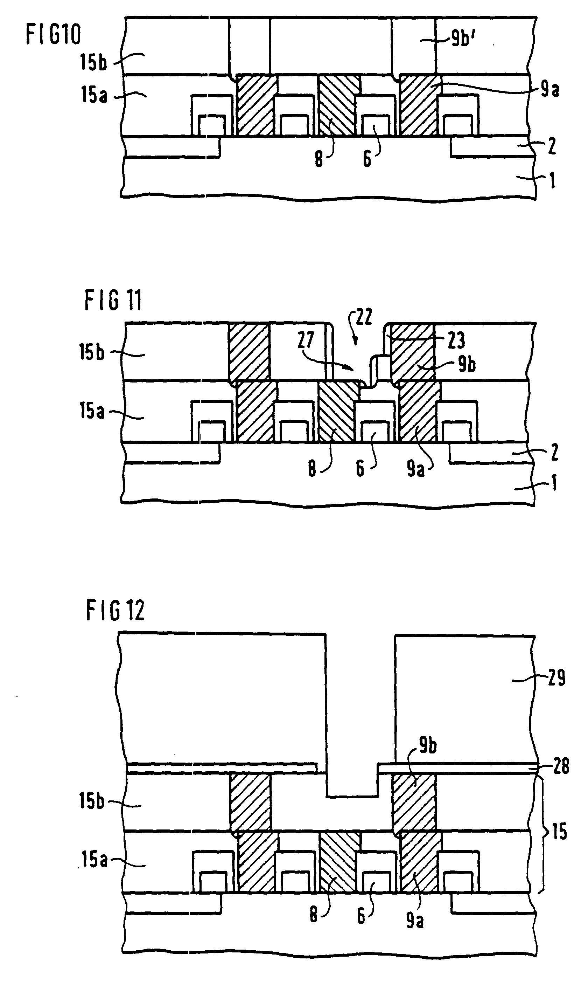

Im folgenden wird anhand der Figuren 3 bis 8 zunächst eine erste Ausführungsform des erfinderischen Verfahrens gemäß einer Basisversion erläutert, anschließend anhand der Figuren 10 bis 25 Varianten der Basisversion für verschiedene Teilschritte. Diese Varianten sind zum Teil auch miteinander kombinierbar. In der ersten Ausführungsform werden CMP Schritte zur Erzeugung der Pfeiler sowie gegebenenfalls in der Bitleitungs-Ebene eingesetzt, spätere Herstellschritte wie die Bildung des Kondensators können beliebig durchgeführt werden. In den Figuren sind die im Prozeß meist unvermeidlichen Dejustagen der Masken von eingesetzten Fototechnikprozessen gegeneinander angedeutet, um die Wirkung der verschiedenen selbstjustierenden Prozeßführungen zu verdeutlichen. Die Bitleitung wird schräg geschnitten, so daß das Bitleitungsraster in den Querschnitten stark verzerrt erscheint.

Bei der Basisversion des Ausführungsbeispiels 1 (sowie ihrer Varianten) wird von einem Halbleitersubstrat 1 ausgegangen, das insbesondere bereits die Trenchisolationsgebiete 2 und Transistoren (3, 4, 5, 6, 20) enthält, wobei das Gate 6 allseits mit einer geeigneten Gateisolation 20 umgeben ist. Zur besseren Übersichtlichkeit sind Gateoxid sowie Source und Drain nicht dargestellt.

### Figuren 3 bis 8:

In der Basisversion des Ausführungsbeispiels 1, ebenso bei den Varianten 1 bis 9, wird die Bitleitung 10 selbst justiert zu den TK-Pfeilern 9 hergestellt. Dementsprechend werden vor der Herstellung der Bitleitung die TK-Pfeiler 9 erzeugt, die etwa 500 nm höher sind als die TB-Pfeiler 8 (diese und folgende Zahlenangaben beziehen sich auf eine beispielhafte Speicherzelle der ungefähren Abmessungen 0,9 µm x 1,8 µm). Dazu wird als erste isolierende Schicht 15 eine Doppelschicht eingesetzt, wobei zunächst in einer unteren Teilschicht 15a der TB-Pfeiler 8, dann eine obere Teilschicht 15b und schließlich TK-Pfeiler 9 in der gesamten ersten isolierenden Schicht 15 hergestellt wird. Die Herstellung von Pfeilern geschieht generell folgendermaßen (in Klammern am Beispiel des TB-Pfeilers gemäß der Basisversion verdeutlicht):
- Abscheidung eines Dielektrikums (untere Teilschicht 15a)
- gegebenenfalls Planarisierung, vorzugsweise in einem CMP-Schritt
- Ätzung von Kontaktlöchern unter Einsatz einer Fototechnik (TB-Kontaktloch in unterer Teilschicht 15a)
- Abscheidung des Pfeilermaterials (selektiv oder ganzflächig), vorzugsweise nach Abscheidung einer Kontakt- und/oder Haftschicht
- Entfernen des Pfeilermaterials auf der planaren Oberfläche des Dielektrikums in einem CMP-Schritt.

Die Kontaktlöcher für die Pfeiler werden wie bereits erläutert vorzugsweise selbstjustiert zum Gate hergestellt. Ferner ist es vorteilhaft, gleichzeitig mit den TB-Pfeilern 8 sämtliche vorgesehene Kontakte von späteren Metallisierungsebenen oder der Bitleitungsebene zu aktiven Gebieten im Halbleitersubstrat sowie zur Wortleitungsebene mit solchen Pfeilern (13, 14 in Fig. 1) zu versehen, weil sonst später unterschiedlich tiefe und teilweise extrem tiefe Kontaktlöcher erforderlich würden.

Bei allen Varianten sind die Angaben zu Bitleitung 10 und TB-Pfeilern 8 daher sinngemäß auch auf die Leitbahnen 12 und die SB- und WB-Pfeiler 13, 14 zu übertragen.

Nach Herstellung der Pfeiler werden die in die erste isolierende Schicht 15, die vorzugsweise aus undotiertem oder dotiertem Siliziumoxid oder aus Siliziumnitrid besteht, mit Hilfe einer Fototechnik (Lackmaske 21) Gräben 22 geätzt, die zur Aufnahme der Bitleitung (im Zellenfeld) bzw. weiterer Leitbahnen (in der Peripherie) dienen. Die Gräben 22 sind so tief, daß die vergrabenen TB-, SB-, WB-Pfeiler 8, 13, 14 am Boden der Gräben freigelegt werden.

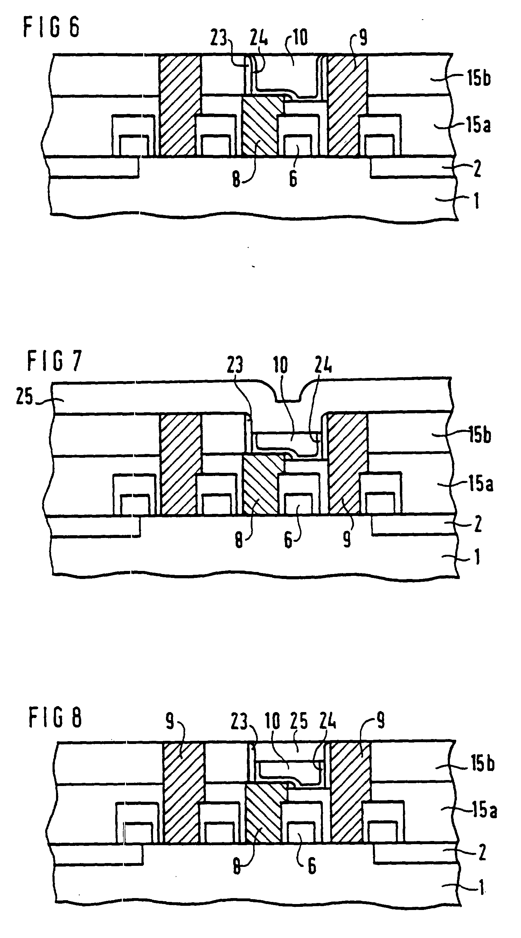

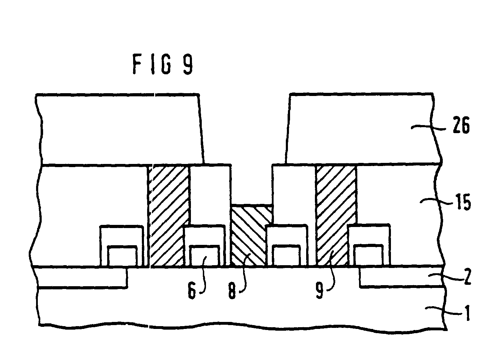

Die Ätzung wird so gewählt, daß die TK-Pfeiler 9 nicht geätzt werden. Das ist mit üblichen Verfahren leicht zu erreichen, wenn z. B. die erste isolierende Schicht 15 ein Siliziumoxid ist und das Material der Pfeiler Silizium oder Wolfram. Es ist zulässig, daß die Lackmaske 21 zur Herstellung des Grabens 22 auch Teile des TK-Pfeilers 9 freilegt. Da die Ätzung, wie erläutert, das Pfeilermaterial nicht angreift, bleiben die Pfeiler an solchen Stellen unbeschädigt (Figur 4). Bevorzugt wird nun eine Flankenisolation 23 an den Grabenwänden erzeugt, z.B. indem ein Dielektrikum von etwa 75 nm Dicke abgeschieden und rückgeätzt wird. Ist die Abscheidung hinreichend konform und die Ätzung anisotrop, so bleiben an allen senkrechten Flanken Spacer 23 zurück (Figur 5). Insbesondere wird die gegebenenfalls freigelegte senkrechte Flanke des TK-Pfeilers 9 durch diesen Spacer 23 seitlich isoliert, andererseits kann die Flankenisolation 23 entfallen, wenn der TK-Pfeiler nicht freigelegt wird. Nun wird vorzugsweise eine Kontakt- und/oder Haftschicht 24, z.B. Ti/TiN und anschließend das Bitleitungsmaterial 10, z.B. Wolfram, abgeschieden. Es kann aber auch eine selektive Abscheidung gewählt werden. Die Dicke wird vorzugsweise so gewählt, daß die geätzten Gräben 22 mindestens bis zur Oberkante der umgebenden ersten isolierenden Schicht 15 aufgefüllt werden. Nun wird das Bitleitungsmaterial 10 sowie ggf. die Haft-/Kontaktschicht 24 in einem CMP-Schritt auf der planaren Oberfläche, d.h. außerhalb der Gräben 22 entfernt, so daß in den Gräben gegeneinander isolierte Leitbahnen 10 zurückbleiben (Figur 6). Am Grabenboden berühren diese Leitbahnen (gegebenenfalls über die Kontakt- und/oder Haftschicht 24) die TB-Pfeiler 8; gegen den TK-Pfeiler 9 sind sie mindestens durch den Spacer 23 isoliert. Das Bitleitungsmaterial wird nun um etwa 200nm zurückgeätzt, wobei die Ätzung selektiv zu den freiliegenden TK-Pfeilern 9 und der ersten isolierenden Schicht 15 ist. Eine Fototechnik wird nicht eingesetzt. Die Ätzung kann anisotrop oder isotrop sein, insbesondere ist auch eine Naßätzung geeignet. Das im Graben verbleibende Bitleitungsmaterial bildet nun die Bitleitung 10 (bzw. in der Peripherie die Leitbahnen 12). Ein Dielektrikum 25 wird abgeschieden, und zwar so dick, daß die vorhandenen Vertiefungen von etwa 200nm mindestens bis zum Niveau der Oberkante der TK-Pfeiler aufgefüllt sind (Figur 7). Mit Hilfe eines CMP-Schrittes wird dieses Dielektrikum auf der planaren Oberfläche wieder entfernt (Figur 8). Die Oberflächen der TK-Pfeiler 9 liegen nun wieder frei, während über der Bitleitung 10 (und den Leitbahnen 12) ein isolierender Deckel 25 verbleibt. Es liegt nun eine Anordnung vor, auf die der Kondensator aufgesetzt werden kann: Die Bitleitung 10 und die anderen in der Bitleitungsebene liegenden Leitbahnen 12 sind durchweg nach oben durch den Deckel 25 isoliert, d.h., die Kondensatoren werden wie gewünscht nur die freigelegten TK-Pfeiler 9, nicht aber die Bitleitung 10 kontaktieren (siehe Figur 1).

### Figur 9: 1. Variante

Werden die Kontaktlöcher selbstjustiert zum Gate 6 bzw. zur Trenchisolation 2 hergestellt, so kann eine Pfeilerherstellung gemäß der 1. oder 2. Variante vorzuziehen sein. Gemäß der 1. Variante werden die TB-, WB-, SB- und TK-Pfeiler zunächst alle gleich hoch hergestellt, und zwar so hoch wie die TK-Pfeiler 9 bei der Basisversion. Die erste isolieren de Schicht 15 wird also als Einfachschicht hergestellt, in die unter Einsatz einer Fototechnik alle Kontaktlöcher geätzt werden. Der Vorteil ist, daß der schwierige Prozeß, Löcher selbstjustiert zu Gate und Trenchisolation herzustellen, nur einmal erforderlich ist. Nach Herstellung aller Pfeiler gemäß dem anfangs erläuterten generellen Ablauf werden die TK-Pfeiler 9 mit einer Lackmaske 26 abgedeckt und die übrigen offenliegenden Pfeiler, die später die Bitleitungsebene kontaktieren werden, um etwa 500nm zurückgeätzt. Diese Ätzung muß selektiv zur ersten isolierenden Schicht 15 sein. Nun liegt im wesentlichen dieselbe Situation vor wie bei der Basisversion, der weitere Prozeßablauf ist gleich (z.B. Herstellung der Gräben 22, ggf. Spacer 23, Auffüllung der Gräben, Bildung des Deckels 25).

### Figur 10-15: 2. Variante

Nach Aufbringen der unteren Teilschicht 15a werden der TB-Pfeiler 8 und ein unterer TK-Pfeiler 9a gleich hoch hergestellt, und zwar so hoch wie der TB-Pfeiler bei der Basisversion. Die zunächst maximal auftretende Pfeilerhöhe ist also um etwa 500nm geringer als in den bisher beschriebenen Varianten, was die auftretenden Prozeßschwankungen merklich verringern kann. Die obere Teilschicht 15b der ersten isolierenden Schicht wird abgeschieden und mit Hilfe einer Fototechnik ein Kontaktloch 9b' für einen oberen TK-Pfeiler 9b geätzt, welches den bereits erzeugten zugehörigen unteren TK-Pfeiler 9a mindestens teilweise freilegt (Fig. 12). Der obere TK-Pfeiler 9b wird wie erläutert hergestellt, so daß eine im wesentlichen gleiche Situation wie bei der Basisversion vorliegt und entsprechend weiterverfahren werden kann.

Es ist jedoch vorteilhaft bzw. bei großen Justierungenauigkeiten notwendig, wenn der Graben für die Bitleitung 10 nicht durch die gesamte obere Teilschicht 15b geätzt wird, da sonst die Gefahr besteht, daß der Grabenboden die horiziontale Oberfläche des unteren TK-Pfeilers 9a freilegt. Eine zuverlässige Isolation dieser horizontalen Oberfläche kann durch die Flankenisolation nicht gewährleistet werden. Das Freilegen kann ausgeschlossen werden, wenn der Graben 22 für die Bitleitung nur bis in eine bestimmte Tiefe der oberen Teilschicht 15b geätzt wird und die Bitleitung über ein Bitleitungskontaktloch 27 an den TB-Pfeiler angeschlossen wird (Figur 11). Dann wird, wie bereits erläutert, eine Flankenisolation 23 zur Isolation des oberen TK-Pfeilers 9b gegen die Bitleitung 10 erzeugt und das Bitleitungskontaktloch 27 gemeinsam mit dem Graben 22 mit dem Bitleitungsmaterial gefüllt.

Die Herstellung des Bitleitungskontaktlochs 27 und des Grabens 22 kann beispielsweise nach dem in dem Artikel von C. W. Kanta et al., VMIC Conference 1991, S. 144 beschriebenen Verfahren erfolgen. Die zusätzliche Maske zur Erzeugung des Bitleitungskontaktloches 27 (BLK-Maske) besitzt eine minimale Strukturgröße, die etwa doppelt so groß ist wie beispielsweise die der Kontaktlochmaske zur Ätzung der unteren Teilschicht 15a. Die BLK-Maske darf die Bitleitung und den unterliegenden TB-Pfeiler (bzw. in der Peripherie die Leitbahn 12 und den unterliegenden Pfeiler 13, 14 vollständig überlappen, sie darf nur nicht einen benachbarten TK-Pfeiler berühren.

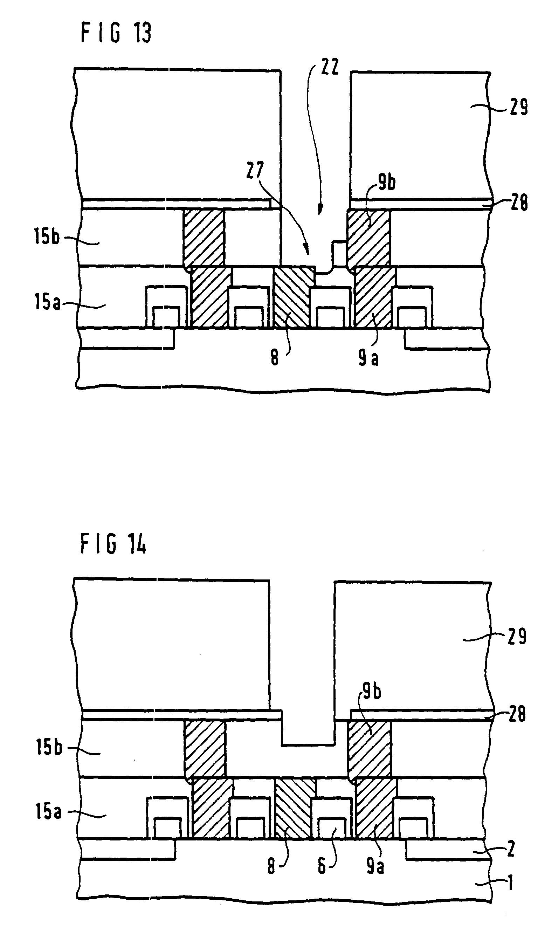

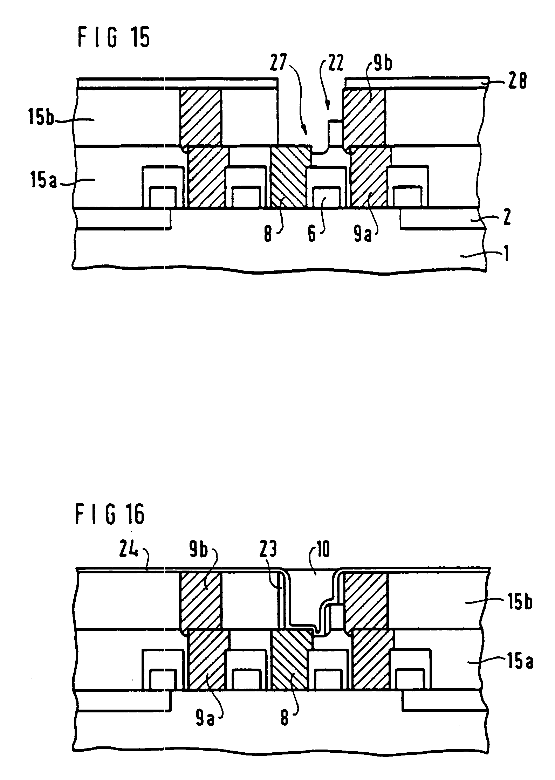

Anstelle der mit Prozeßunsicherheiten behafteten "doppelten Fototechnik" gemäß der oben angegebenen Literaturstelle kann folgendermaßen vorgegangen werden: Auf die Oberfläche der ersten isolierenden Schicht 15 und der TK-Pfeiler 9 wird eine erster Maskenschicht 28' z.B. aus Titan-Nitrid oder Polysilizium abgeschieden. Anschließend wird
- entweder die erste Maskenschicht 28' mit der BLK-Maske zur 1. Maske 28 strukturiert. Eine im allgemeinen aus Lack bestehende und entsprechend der Bitleitungsebene strukturierte zweite Maske 29 wird darüber hergestellt. Selektiv zur ersten und zur zweiten Maske wird nun in die obere Teilschicht 15b bis in eine bestimmte Tiefe geätzt (Figur 12). Nun wird die erste Maske 28 an den Stellen, die nicht mit der zweiten Maske 29 bedeckt sind, entfernt und die erste Isolationsschicht 15 so weit geätzt, bis das Bitleitungskontaktloch 27 die Oberfläche 27 die Oberfläche des TB-Pfeilers 8 freilegt (Figur 13),
- oder die erste Maskenschicht 28' entsprechend der Bitleitungsebene strukturiert. Die mit der BLK-Maske strukturierte zweite Maske 29 wird hergestellt und wieder die obere Teilschicht 15b selektiv zur ersten und zur zweiten Maske bis in eine bestimmte Tiefe geätzt (Figur 14). Die zweite Maske wird entfernt und die erste Isolationsschicht selektiv zur ersten Maske weiter geätzt, bis das Bitleitungskontaktloch 27 die Oberfläche des TB-Pfeilers freilegt (Figur 15).

Der Einsatz der BLK-Maske eröffnet zusätzlich die Möglichkeit, Leitbahnen 12 in der Bitleitungsebene außerhalb des Zellenfeldes, wo keine TK-Pfeiler vorkommen, in zwei verschiedenen Dicken herzustellen, je nachdem ob die BLK-Maske offen oder zu ist. Leitbahnen, die niedrige Widerstände zeigen sollen, werden durch eine offene BLK-Maske (28 oder 29) mit großer Schichtdicke hergestellt, Leitbahnen, die minimale Kapazität zu unterliegenden und Nachbarleitbahnen zeigen sollen, werden durch eine geschlossene BLK-Maske (28 oder 29) mit geringer Schichtdicke hergestellt. Zu beachten ist dabei, daß über den SB- und WB-Pfeilern 13, 14 die BLK-Maske immer offen ist.

Zusätzlich kann die erste isolierende Schicht 15 (oder ihre obere Teilschicht 15b) so gewählt werden, daß der CMP Schritt zur Herstellung des Deckels auf der Bitleitung selektiv zur ersten isolierenden Schicht durchgeführt werden kann. Beispielsweise ist es möglich, Oxid selektiv gegen Nitrid zu schleifen, so daß die erste isolierende Schicht vorzugsweise aus einer Oxid- und einer Nitridschicht gebildet wird. Der Deckel wird wieder aus Oxid gebildet. Der Vorteil ist, daß die Dicke des Deckels gleichmäßig und gut definiert ist, insbesondere wird verhindert, daß der Deckel im CMP-Schritt ganz durchstoßen wird.

### Figur 16: 3. Variante

Ist eine zum TK-Pfeiler 9 selektive Rückätzung des Bitleitungsmaterials unter die Grabenkante nicht möglich oder schwierig - etwa weil beide aus demselben Material bestehen - so kann beim CMP-Schritt zur Erzeugung der Bitleitung auf einer unterliegenden leitenden Haft-/Kontaktschicht 24 gestoppt werden. Ist das Bitleitungsmaterial beispielsweise Wolfram, so ist Titan-Nitrid eine häufig verwendete Hafttivität gestoppt werden kann. Der TK-Pfeiler 9 ist jetzt also mit TiN bedeckt, während im Graben das Wolfram 10 offen liegt (Fig. 16). Nun kann Wolfram selektiv zu TiN unter die Grabenoberkante geätzt werden; solche Ätzprozesse sind bekannt und werden häufig zur Erzeugung von Wolframauffüllungen in Kontaktlöchern eingesetzt. TiN wird mit einer weiteren Ätzung entfernt. Diese Ätzung entfernt nur die dünne TiN-Schicht und kann deshalb kurz gehalten werden. Selbst wenn sie nicht selektiv zum TK-Pfeiler sein sollte, wird also der TK-Pfeiler 9 nur unwesentlich abgetragen und ragt in jedem Fall über die Oberkante der fertiggestellten Bitleitung 10 hinaus. Die Bitleitung kann nun wie oben beschrieben mit einem isolierenden Deckel versehen werden.

### 4. Variante

Das Bitleitungsmaterial wird mittels eines Sputter- oder Aufdampfverfahrens so aufgebracht, daß es fast nur auf horizontalen, kaum jedoch auf vertikalen Gebieten abgeschieden wird. Man erreicht dies z. B., indem das Material von einer nahezu punktförmigen Quelle auf die vorhandene Oberfläche aufgedampft wird, die in weiter Entfernung senkrecht über dem Substrat angebracht ist. Die dünne Schicht des Bitleitungsmaterials an den Grabenwänden kann erforderlichenfalls noch mit einer kurzen isotropen Ätzung vollständig entfernt werden. Die auf horizontalen Oberflächen abgeschiedene Schichtdicke wird so gewählt, daß der Graben 22 nicht ganz bis zur Grabenoberkante mit dem Bitleitungsmaterial gefüllt ist. Nun wird ein Dielektrikum abgeschieden und dieses sowie das Bitleitungsmaterial auf der planaren Oberfläche in einem CMP-Schritt entfernt. Im Graben 22 verbleibt dabei die Bitleitung 10 mit einem isolierenden Deckel 25.

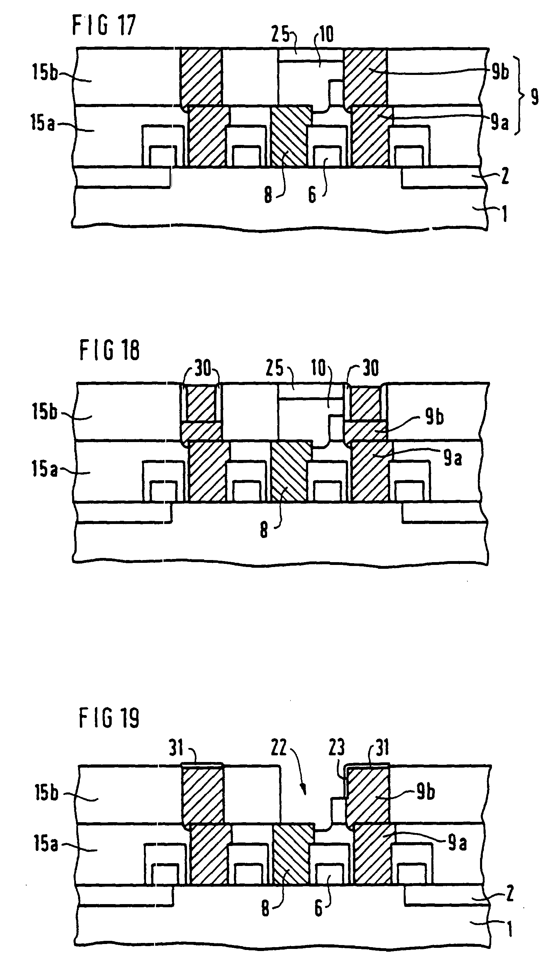

### Figur 17-18: 5. Variante

Der Spacer 23 zur Isolation der Bitleitung gegen den TK Pfeiler 9 wird zunächst weggelassen. Dieser Spacer verringert die Bahnbreite der Bitleitung 10 so daß ein Prozeß ohne Spacer Vorteile besitzen kann. Nachdem auf der Bitleitung 10 ein isolierender Deckel 25 hergestellt ist, liegt die Oberfläche der TK-Pfeiler 9 offen, während die Bitleitung überall durch den Deckel 25 geschützt ist (Figur 17). Nun kann also ohne weitere Maske selektiv zur 1. isolierenden Schicht und zum Deckel 25 der TK-Pfeiler 9 rückgeätzt werden, und zwar tiefer als die Unterkante der Bitleitung 10. Nun wird eine Flankenisolation , z. B. ein Spacer 30 an den Wänden des entstandenen Lochs hergestellt und das Loch mit einem geeigneten leitenden Material, z.B. dotierten Polysilizium, gefüllt (Figur 18). Der Spacer 30 isoliert nun wiederum den TK-Pfeiler gegen die Bitleitung 10.

Gemäß einer ähnlichen Variante wird der Spacer 23 im Graben 22 nicht ganz weggelassen, sondern nur schmaler hergestellt; der Spacer 30 wird wie eben beschrieben relativ schmal hergestellt. Die beiden Spacer 23 und 30 liegen nebeneinander, die Dicke der Isolation zwischen Bitleitung 10 und TK-Pfeiler 9 ist die Summe der beiden Spacerbreiten. Je nach den gegebenen Randbedingungen kann die erforderliche Dicke al so frei auf beide Spacerbreiten aufgeteilt werden. Ein weiterer Vorteil des Vorgehens, den Spacer 23 im Bitleitungsgraben nicht ganz wegzulassen, tritt bei der Rückätzung des TK-Pfeilers auf. Liegt im Bitleitungsgraben 22 kein Spacer, so muß die Rückätzung offenbar anisotrop sein, um das Bitleitungsmaterial nicht zu beschädigen, andererseits dürfen entlang der Lochflanke keine Reste des Pfeilermaterials verbleiben. Ist die Bitleitung 10 durch einen dünnen Spacer 23 geschützt, kann auch eine isotrope Rückätzung des TK Pfeilers 9 verwendet werden, beispielsweise derselbe Ätzprozeß wie bei der ersten Rückätzung des TB-Pfeilers.

### 6. Variante:

Besteht die Bitleitung 10 aus einem Material, das ein nichtleitendes beständiges Oxid besitzt (beispielsweise dotiertes Polysilizium), so kann der Deckel 25 auch durch eine Oxidation hergestellt werden. Voraussetzung ist, daß der TK-Pfeiler 9 aus einem Material besteht, das bei dieser Oxidation nicht oder ausreichend langsamer oxidiert als das Bitleitungsmaterial. Ein gegebenenfalls gebildetes dünnes Oxid auf dem TK-Pfeiler kann mittels einer Ätzung oder in einem CMP-Schritt entfernt werden, ohne den dickeren Deckel über der Bitleitung zu durchstoßen. Statt einer Oxidation kann hier - und bei den folgenden Varianten - auch eine andere geeignete chemische Reaktion verwendet werden, die aus einem leitenden Material ein beständiges Material erzeugt, z.B. eine Nitridation.

### Figur 19: 7. Variante

Besteht der TK-Pfeiler aus einem Material, das ein nicht leitendes beständiges Oxid besitzt (z. B. dotiertes Polysilizium), so kann die Flankenisolation 23 zur Isolation zwischen der Bitleitung 10 und dem TK-Pfeiler 9 auch durch eine Oxidation nach Ätzung der Bitleitungsgräben 22 hergestellt werden; die Flankenisolation 23 besteht dann aus dem Oxid des Pfeilermaterials. Spätestens beim CMP-Schritt zur Erzeugung des Deckels wird das gebildete Oxid 31 auf der horizontalen Oberfläche des TK-Pfeilers 9 wieder entfernt, um den TK-Pfeiler nach oben zu öffnen. Ein Vorteil bei dieser Variante ist, daß der Graben 22 selbst nicht durch den Spacer verschmälert wird. Falls nach Ätzung des Grabens am Grabenboden der TB-Pfeiler offenliegt, ist eine Voraussetzung, daß das Material des TB-Pfeilers 8 während dieser Oxidation nicht oder ausreichend langsamer oxidiert als der TK-Pfeiler 9 (beispielsweise besteht der TB-Pfeiler aus niedriger dotiertem Polysilizium als der TK-Pfeiler). Ein Vorgehen ähnlich der zweiten Variante ist ebenfalls möglich: In diesem Fall ätzt man den Graben 22 nicht bis auf den TB-Pfeiler 8 herunter, sondern öffnet diesen Pfeiler erst nach der Oxidation des TK-Pfeilers mit einer separaten Maske. Der TB-Pfeiler 8 liegt also während der Oxidation nicht frei, so daß dort kein oder ein wesentlich dünneres Oxid gebildet wird als auf dem TK-Pfeiler 9.

### 8. Variante:

Eine Oxidschicht 31 auf dem TK-Pfeiler 9 gemäß der 7. Variante kann auch bei der Rückätzung der Bitleitung unter die Grabenoberkante verwendet werden. In diesem Fall wird der CMP-Schritt zur Erzeugung der Bitleitung selektiv zu dem Oxiddeckel 31 des TK-Pfeilers durchgeführt. Bei der Rückätzung der Bitleitung wird nun der TK-Pfeiler durch den Oxiddeckel 31 geschützt.

### 9. Variante:

Der Oxiddeckel 31 auf dem TK-Pfeiler 9 kann auch nach dem CMP-Schritt zur Erzeugung der Bitleitung hergestellt werden, vorausgesetzt, das Bitleitungsmaterial oxidiert bei der Oxidation nicht oder nur langsam (z.B. niedrig dotiertes Polysilizium). Der Oxiddeckel 31 schützt dann wie bei der 8. Variante den TK-Pfeiler während der Rückätzung der Bitleitung unter die Grabenoberkante.

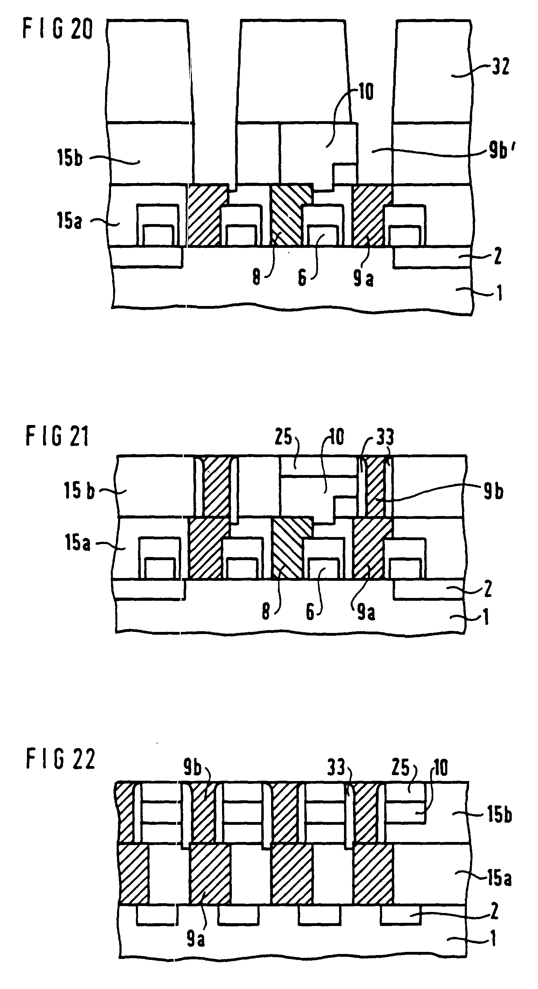

### Figur 20-22: 10. Variante

Im Unterschied zu den bisher geschilderten Varianten werden bei der 10. und 11. Variante nicht die Bitleitung selbstjustiert zu den TK-Pfeilern, sondern der obere TK-Pfeiler 9b selbstjustiert zur Bitleitung 10 hergestellt. Wie bei der 2. Variante werden zunächst in der unteren Teilschicht 15a der ersten isolierenden Schicht 15 der TB-Pfeiler 8 und der untere TK-Pfeiler 9a hergestellt. Es wird die obere Teilschicht 15b aufgebracht, aber zunächst kein oberer TK-Pfeiler 9b hergestellt. Das Bitleitungskontaktloch 27 und der Bitleitungsgraben 22 werden aufgefüllt (10), wobei zunächst kein Deckel aufgesetzt wird. Mit Hilfe einer Fototechnik (Lackmaske 32) werden Kontaktlöcher 9b' geätzt, die die Oberfläche der unteren TK-Pfeiler 9a genügend frei legen. Die Ätzung der ersten isolierenden Schicht 15 erfolgt dabei selektiv zum Bitleitungsmaterial (Figur 20). In das Loch, d.h. auch an die ggf. freigelegte Flanke des Bitleitungsmaterials 10, wird eine Flankenisolation z. B. ein Oxidspacer eingebracht. Das verbleibende Loch wird mit dem oberen TK-Pfeiler 9b gefüllt, dann wird mit einem der bereits erläuterten Verfahren der Deckel 25 auf der Bitleitung 10 hergestellt (Figur 21).

Vorteilhaft bei dieser Variante ist, daß die Bitleitung nicht durch Spacer verschmälert wird. Anderereits wird der Durchmesser des oberen TK-Pfeilers 9b durch den Spacer 33 verringert. Es ist jedoch möglich, die Öffnung in der Lackmaske 32 (zur Erzeugung des oberen TK-Pfeilers) beliebig weit über die Bitleitung 10 zu ziehen. D.h. der gesamte zwischen zwei Bitleitungen verfügbare Raum (abzüglich der Spacer 33) steht für den Kontakt zur Verfügung. Figur 22 zeigt einen Querschnitt durch das Halbleitersubstrat in Wortleitungs-Richtung in Höhe der TK-Pfeiler (vgl. Figur 2), an dem deutlich wird, daß der zur Verfügung stehende Platz optimal genutzt wird.

### 11. Variante:

Die unteren TK-Pfeiler 9a werden so hergestellt, daß sie niedriger sind als die TB-, SB- und WB-Pfeiler 8, 13, 14, wozu ein der Basisversion oder der 1. Variante analoges Verfahren eingesetzt werden kann. Mit der Ätzung des Bitleitungsgrabens 22 wird der TB-Pfeiler 8 (und die Pfeiler in der Peripherie), nicht aber die tieferliegenden unteren TK-Pfeiler 9a geöffnet. Der weitere Ablauf kann ähnlich der 10. Variante erfolgen.

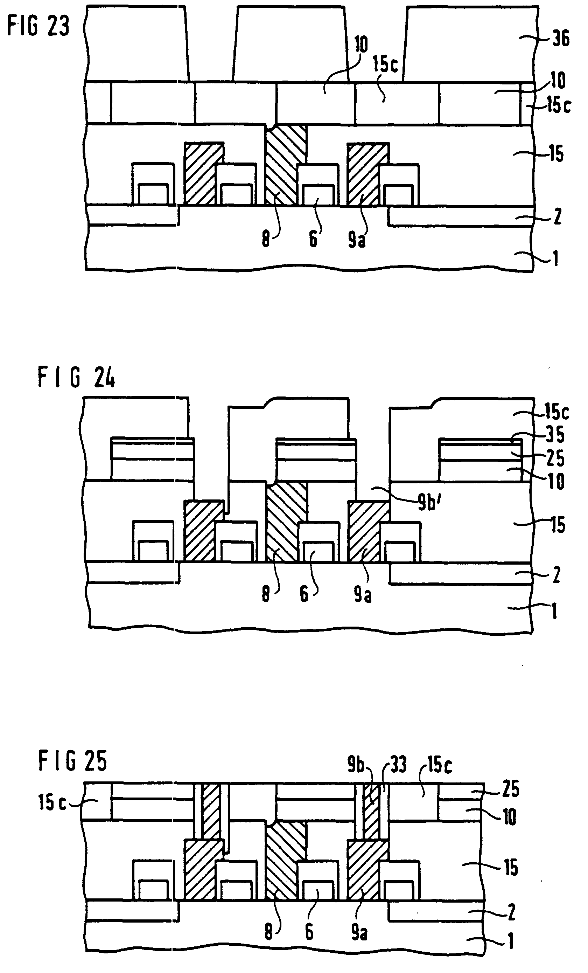

### Figur 23: 12. Variante

Die Bitleitung 10 und die weiteren Leitbahnen 12 in der Bitleitungsebene können auch mit Hilfe einer konventionellen Strukturierung hergestellt werden. Mit einer der dargestellten Prozeßvarianten werden Kontaktpfeiler hergestellt, und zwar so, daß die TB-, SB- und WB-Pfeiler 8, 13, 14 offenliegen, während die unteren TK-Pfeiler 9 von der ersten isolierenden Schicht 15 bedeckt sind. Nun wird das Bitleitungsmaterial ganzflächig abgeschieden und mit Hilfe einer Fototechnik strukturiert. Eine nichtleitende Planarisierungsschicht 15c zur Auffüllung der Spalte zwischen den so erzeugten Leitbahnen 10, 12 wird abgeschieden und ggf. beispielsweise in einem CMP-Schritt planarisiert (Figur 23). Der CMP-Schritt wird vorzugsweise so durchgeführt, daß die Oberfläche des Bitleitungsmaterials 10 nicht von der Planarisierungsschicht 15c bedeckt wird. Nun werden mit Hilfe einer Fototechnik (Lackmaske 36) die Kontaktlöcher für den oberen TK-Pfeiler geätzt, wobei die Ätzung selektiv zum Bitleitungsmaterial durchgeführt wird. Das Kontaktloch öffnet die Oberfläche der vergrabenen unteren TK-Pfeiler 9a. Wie bereits erläutert, wird ein Spacer in das Loch eingebracht, anschließend wird der obere TK-Pfeiler 9b aufgesetzt. Nach Rückätzung des Bitleitungsmaterials zur Bitleitung 10 wird diese mit einem Deckel 25 versehen. Bei dieser Variante kann es notwendig sein, zur Aufrechterhaltung der globalen Planarität der Speicheranordnung an den Stellen Dummy-Strukturen in der Bitleitungsebene vorzusehen, an denen zu breite Abstände zwischen den Leitbahnen 12 vorliegen; alternativ können diese Gebiete auch mit einem Dielektrikum aufgefüllt werden.

### Figur 24-25, 13. Variante:

Es wird wie bei der vorhergehenden Variante 12 verfahren, jedoch wird nicht nur das Bitleitungsmaterial abgeschieden und strukturiert, sondern eine Dreifachschicht bestehend aus Bitleitungsmaterial, Deckelmaterial 25 und Ätzstopschicht 35. Die Ätzstopschicht 35 kann dünn sein und besteht beispielsweise aus Polysilizium, Titannitrid oder Wolfram. Nach Abscheidung der Planarisierungsschicht 15c zur Auffüllung der Spalte wird das Kontaktloch 9b für den oberen TK-Pfeiler 9b geätzt, wobei die Ätzung selektiv zur Ätzstopschicht erfolgt (Figur 24). Wieder wird ein Spacer 33 im Loch 9b erzeugt. Nach Abscheidung des Pfeilermaterials zur Auffüllung des Lochs wird in einem Mehrfach-CMP Schritt das Pfeilermaterial, die Planarisierungsschicht 15c und die Ätzstopschicht 35 abgetragen (Figur 25). Die einzelnen CMP-Schritte werden vorteilhaft so auf die Materialien abgestimmt, daß entweder auf der Ätzstopschicht 35 gestoppt wird und diese dann mit einem kurzen und damit präzisen CMP-Schritt entfernt wird, oder auf dem Deckel 25 gestoppt wird.

Der Vorteil dieser Variante ist, daß die Dicken der Bitleitung 10 und des Deckels 25 nicht durch eine Rückätzung, sondern im wesentlichen durch Schichtabscheidungen - und damit im allgemeinen gleichmäßiger und genauer - definiert sind.

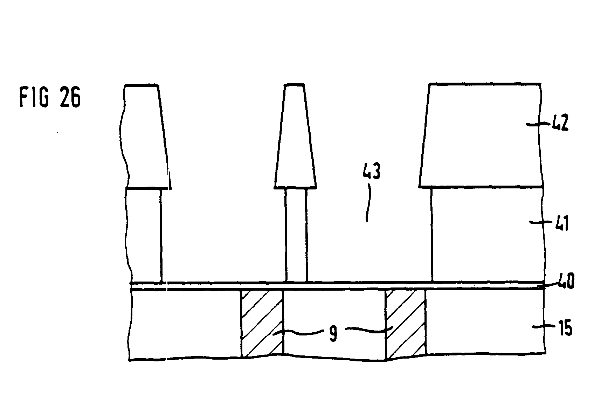

### Figur 26-29: 2. Ausführungsform

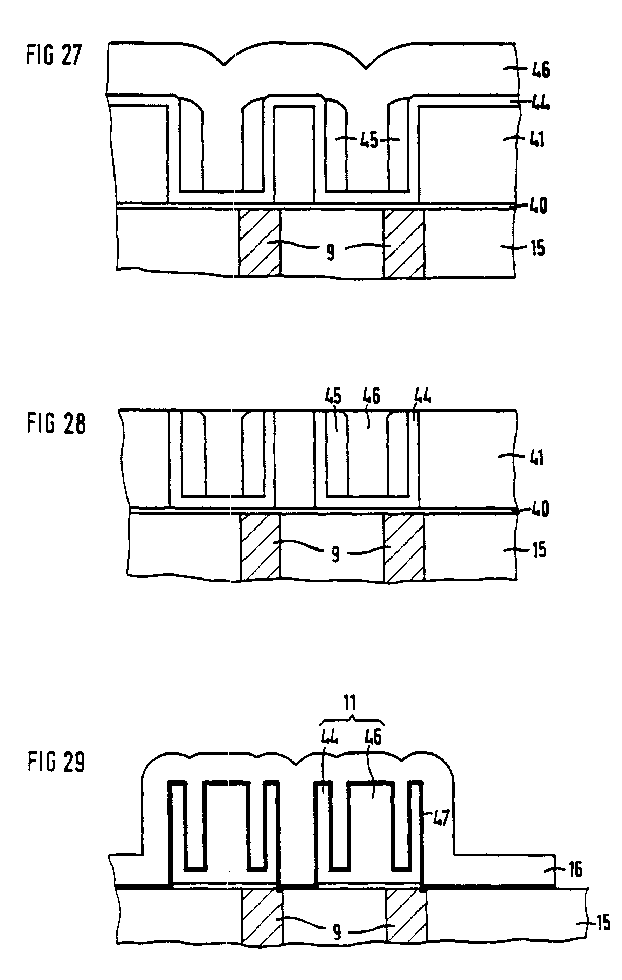

In der zweiten Ausführungsform des erfindungsgemäßen Verfahrens wird auch bei der Herstellung des Stacked-Capacitor auf der nun vorliegenden global planarisierten Oberfläche der ersten isolierenden Schicht 15 oder der Planarisierungsschicht 15c ein CMP-Schritt eingesetzt. Es wird ein sogenannter "Schüsselkondensator" erzeugt, der eine Erhöhung der Kondensatorfläche und damit der Kapaztität auf einer gegebenen Grundfläche ermöglicht. Die allgemeine Herstellung eines solchen Schüsselkondensators ist beispielsweise in Toru Kaga et al., IEEE Trans. on ED, Vol. 38, No. 2, Febr. 1991, S. 255, beschrieben und wird deshalb hier, erweitert um einige Schritte, nur in Stichpunkten dargestellt:
a) Abscheidung eines dünnen dotierten Polysiliziums 40 als Ätzstop und zur Bildung eines definierten Untergrundes
b) Abscheidung eines dicken Siliziumoxids 41
c) Anisotrope Ätzung von Löchern 43 in dieses Oxid 41 an den Stellen, wo später ein Kondensator entstehen soll, mit Hilfe einer Fototechnik (Lackmaske 42)
d) Gegebenenfalls isotrope Oxidätzung zur Vergrößerung des Lochs 43 vor Entfernung der Lackmaske 42 (Figur 26)
e) Abscheidung eines weiteren dotierten Polysiliziums 44
f) Herstellung eines Oxidspacers 45
g) Gegebenenfalls einmalige oder mehrmalige Wiederholung der letzten beiden Schritte zur Erzeugung einer "Mehrfachschüssel"
h) Abscheidung eines dotierten Polysiliziums 46 zur Verfüllung der restlichen Löcher (Figur 27)
i) Entfernung des Polysiliziums 46, 44 auf der planaren Scheibenoberfläche außerhalb des Lochs 43 mit Hilfe eines CMP-Schrittes (Figur 28)
k) Entfernung des Oxids 41, und der Oxidspacer 45 beispielsweise mittels einer Naßätzung, selektiv zum Polysilizium 44, 46, 40
1) Vorzugsweise anisotrope Ätzung der ersten dünnen Polysiliziumschicht 40
m) Abscheidung eines Kondensatordielektrikums 47, (z. B. ONO), Abscheidung und Strukturierung der Gegenplatte 16 aus Polysilizium (Figur 29).

Das Polysilizium 46, 44 wird auf der planaren Oberfläche nicht durch ein Ätzung, sondern durch einen CMP-Schritt entfernt (Schritt i). Die Oberkanten der unteren Kondensatorelektrode 11 (d. h. die Oberkante des aus der Polysiliziumschicht 44 gebildeten "Schüsselrandes" und die Oberkanten der in Schritt g) sowie h) aus der Polysiliziumschicht 46 gebildeten in der Schüssel liegenden "Lamellen") besitzen dadurch im wesentlichen dieselbe Höhe. Der Vorteil ist, daß die Kondensatoren eine planare und in der Höhe gut definierte obere Deckfläche aufweisen. Polysilizium kann mit hoher Selektivität gegen Oxid geschliffen werden, so daß auf dem Oxid 41 problemlos gestoppt werden kann. Ferner ist es vorteilhaft, wenn ein isotroper Oxidätzprozeß zur Vergrößerung der Löcher eingefügt wird (Schritt d). Dadurch vergrößert sich der Kondensatorumfang und damit die Speicherkapazität, außerdem wird es einfacher, die Kondensatoren voll überlappend über die TK-Pfeiler 9 zu legen. Das ist wichtig, wenn die TK-Pfeiler 9 aus einem Material bestehen, auf dem kein verläßliches Kondensatordielektrikum 47 hergestellt werden kann. Dann muß verhindert werden, daß die TK-Pfeiler 9 neben der unteren Kondensatorelektrode 11 teilweise freigelegt werden, wie dies in Figur 29 der Fall ist. Die Gegenplatte 16 ist vorzugsweise so dick abzuscheiden, daß alle Spalten zwischen den Polysilizium-Lamellen eines Kondensators und zwischen benachbarten unteren Kondensatorelektroden aufgefüllt werden. Auch dies wird vereinfacht, wenn der Spalt zwischen den Kondensatoren durch die erwähnte isotrope Oxidätzung verschmälert wird. Die Dicke der Gegenplatte 16 kann reduziert werden, was die Gesamthöhe der Kondensatoren verringert und die Planarisierung erleichtert.

Erkennnbar ist die Oxidschicht 41 nur eine Hilfsschicht, die ebenso wie die Oxidspacer 45 später wieder entfernt wird. Diese beiden Strukturen 41, 45 können daher aus anderen Materialien bestehen, die die oben erläuterten Bedingungen erfüllen. Vorzugsweise bestehen sie aus demselben Material, so daß sie im Schritt k) gemeinsam entfernt werden können.

Weitere Einzelheiten sind in der deutschen Patentanmeldung DE-A-42 21 431 beschrieben.

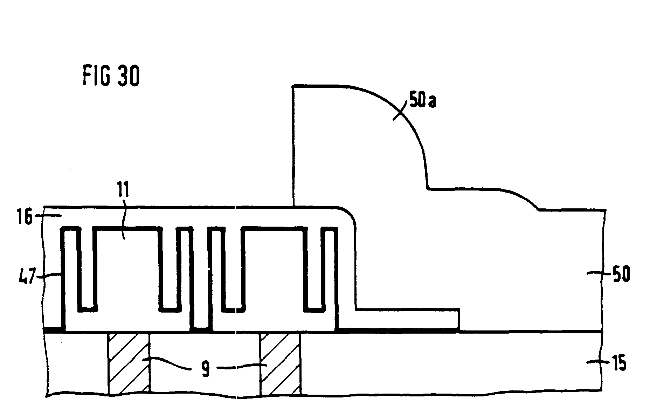

### Figur 30-32: 3. Ausführungsform

In einer dritten Ausführungsform sieht das Herstellverfahren für die Halbleiterspeicheranordnung vor, auch zur globalen Planarisierung der gesamten Anordnung, also insbesondere von Zellenfeld und Peripherie, einen CMP-Schritt einzusetzen.

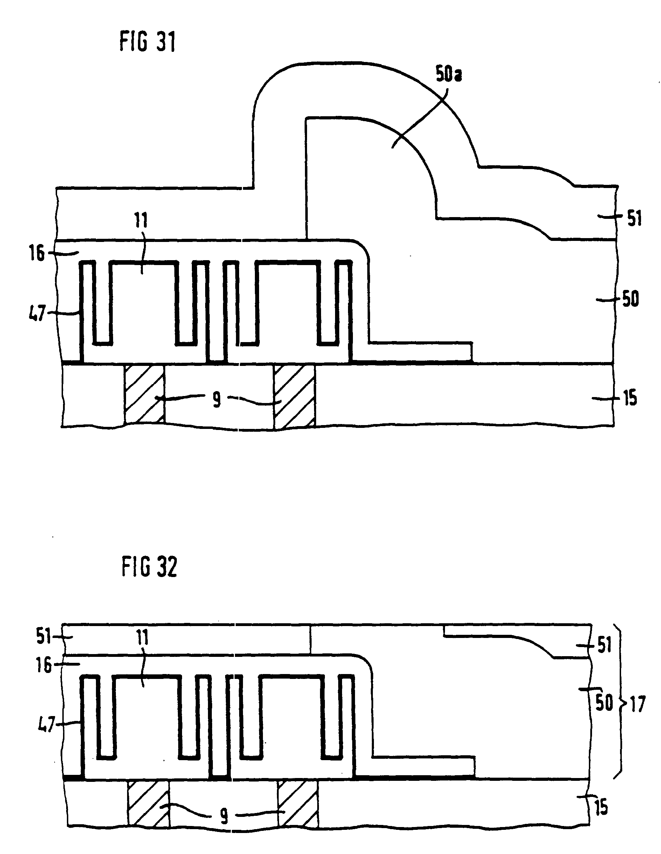

Nach der Herstellung der Gegenplatte 16 wird ein erstes Dielektrikum 50 abgeschieden, dessen Dicke genau gleich der Höhe der Kondensatoren (einschließlich der Gegenplatte) 11, 47, 16 ist. In der Praxis kann dies dadurch erreicht werden, daß die Höhe der Kondensatoren mittels Profilometrie gemessen wird und die Schichtdicke auf diesen Wert eingestellt wird. Anschließend wird das erste Dielektrikum 50, z.B. Siliziumoxid von 500nm - 1000nm Dicke, mittels einer Fototechnik in einem geeigneten Ätzprozeß im Zellenfeld wieder vollständig entfernt, wobei am Rand des Zellenfeldes ein Steg 50a verbleibt. Abgesehen von diesem Steg 50a ist die Oberfläche nun bereits global planar (Figur 30). Die Breite des Stegs 50a hängt im wesentlichen von der erreichbaren Justiergenauigkeit der verwendeten Fototechnik ab und liegt in der Größenordnung 1 Mikrometer. So schmale Stege, die zusätzlich einen großen gegenseitigen Abstand von etwa 100 Mikrometern aufweisen, können durch das Schleifverfahren leicht planarisiert werden. Erfindungsgemäß wird dazu ein zweites Dielektrikum 51 von etwa 500 nm Dicke, meist ebenfalls Siliziumoxid abgeschieden (Figur 31), dann wird ein Teil der Dicke dieses zweiten Dielektrikums, beispielsweise 200 nm, in einem CMP-Schritt abgetragen. Über den Stegen 50a wird es vollständig entfernt, gleichzeitig wird der Steg mit abgetragen (Figur 32). Nun liegt also eine global planarisierte Oberfläche der Halbleiterspeicheranordnung vor.

Die Gleichmäßigkeit des Abtrags in dem CMP-Schritt über eine gesamte, mehrere Speicheranordnungen enthaltende Halbleiterscheibe ist meist nicht besonders gut. Die Erfindung sieht deshalb einen Planarisierungsprozeß vor, bei dem ein möglichst geringer Abtrag in dem CMP-Schritt erforderlich ist. Ein besonderer Vorteil des erfinderischen Verfahrens ist, daß die Gleichmäßigkeit bei der Ätzung des ersten Dielektrikums 50, die u.U.ebenfalls schlecht ist, keinen Einfluß auf die später vorliegenden Schichtdicken hat, da bei der Ätzung auf der Gegenplatte 48 gestoppt wird. Im wesentlichen ist die Schichtdicke außerhalb des Zellenfeldes also durch weitgehend präzise definierte Abscheidungen gegeben. Dies ist besonders vorteilhaft, da dadurch in der Peripherie sogenannte "Non-Nested" Kontaktlöcher zu den Leitbahnen in der Bitleitungsebene hergestellt werden können (siehe Figur 1, Kontaktloch 19), d. h. die Kontaktlöcher 19 können über die Kante der Leitbahn 12 hinausreichen, so daß der Platzbedarf der Schaltung stark verringert wird. Bei Non-Nested-Vias kann das Problem auftreten, daß die Kontaktlochätzung an der Leitbahn vorbei bis zu unterliegenden Leitbahnebenen reicht und damit Kurzschlüsse zwischen der Kontaktlochauffüllung und diesen tieferen Leitbahnen entstehen. Die Ätzung der Kontaktlöcher 19 muß deshalb früh genug abgebrochen werden, bevor tiefere Leitbahnen erreicht werden. Andererseits muß natürlich jedes Kontaktloch 19 bis zur Leitbahn 12 reichen. Es ist also erforderlich, daß die Schichtdicke des gesamten Dielektrikums über der Leitbahn 12 genau bekannt und über die Halbleiterscheibe ausreichend gleichmäßig ist. Dies wird durch die erfindungsgemäße globale Planarisierung in hohem Maße gewährleistet. Gleichzeitig mit den Kontaktlöchern 19 zur Bitleitungsebene werden Kontaktlöcher 18 zum Anschluß der Gegenplatte 16 hergestellt. Durch das erfindungsgemäße Herstellverfahren liegt die Gegenplatte 16 in einem Randstreifen rund um das Zellenfeld nicht viel höher als die Leitbahnen 12 in der Bitleitungsebene, so daß die Überätzung auf der Gegenplatte bei der Ätzung des Kontaktlochs 19 gering ist. Es wird dadurch vermieden, daß die Gegenplatte bei der Kontaktlochätzung durchgeätzt wird.

Weitere Einzelheiten sind in der deutschen Patentanmeldung DE-A-42 21 432 beschrieben.

## Patentansprüche

1. Halbleiterspeicheranordnung mit Ein-Transistor-Speicherzellen, wobei jede Speicherzelle
- einen in einem Halbleitersubstrat (1) angeordneten Transistor (3, 4, 6),
- eine oberhalb des Transistors angeordnete Bitleitung (10) und einen oberhalb der Bitleitung angeordneten Kondensator (11, 47, 48),
- einen Transistor-Kondensator-Pfeiler (9) (TK-Pfeiler), zur elektrischen Verbindung eines ersten S/D-Gebiets (3) des Transistors mit einer auf einer ersten isolierenden Schicht (15) oder Planarisierungsschicht (15c) angeordneten unteren Kondensatorplatte (11) und
- einen Transistor-Bitleitungs-Pfeiler (8) (TB-Pfeiler) zur elektrischen Verbindung eines zweiten S/D-Gebiets (4) mit der Bitleitung (10) aufweist,
wobei
a) die Oberkanten der TB-Pfeiler (8) verschiedener Speicherzellen in einer planarisierten Fläche liegen und
b) die Oberkanten von auf den Bitleitungen (10) angeordneten isolierenden Deckeln (25), der ersten isolierenden Schicht (15) oder Planarisierungsschicht (15c) und der TK-Pfeiler (9 in einer weiteren planaren Flächeliegen.
**dadurch gekennzeichnet,**
daß weitere Leiterbahnen (12) in der Bitleitungsebene vorgesehen sind, die über einen Substrat-Pfeiler (13) (SB-Pfeiler) mit dem Halbleitersubstrat (1) elektrisch verbunden sind,
daß weitere Leiterbahnen (12) in der Bitleitungsebene vorgesehen sind, die über einen Wortleitungspfeiler (14) (WB-Pfeiler) mit weiteren unterliegenden Leitbahnen (7), die in der Wortleitungsebene angeordnet sind, elektrisch verbunden sind,
daß die Oberkanten der TB-, SB- und WB-Pfeiler (8, 13, 14) geschliffen sind und in der planarisierten Fläche der Oberkante der TB-Pfeiler liegen ,wobei diese Fläche global planarisiert ist, und
daß die weitere planare Fläche im Rahmen von Prozeßschwankungen global planar ist.

2. Halbleiterspeicheranordnung nach Anspruch 1, **gekennzeichnet durch** eine Flankenisolation (23), die die Bitleitung (10) gegen einen Teil des TK-Pfeilers (9) isoliert.

3. Halbleiterspeicheranordnung nach einem der Ansprüche 1 bis 2 , **gekennzeichnet durch** ein Bitleitungskontaktloch (27), über das die Bitleitung (10) an den TB-Pfeiler (8) angeschlossen ist.

4. Halbleiterspeicheranordnung nach einem der Ansprüche 1 bis 3 , **dadurch gekennzeichnet**, daß die Oberkanten der unteren Kondensatorplatten (11) geschliffen sind und in einer global planarisierten Fläche liegen.

5. Halbleiterspeicheranordnung nach einem der Ansprüche 1 bis 4 , **dadurch gekennzeichnet**, daß die Oberkanten von Zellenfeldern (Z) und Peripheriegebieten (P) geschliffen sind und in einer global planarisierten Fläche liegen.

6. Herstellverfahren für eine Halbleiterspeicheranordnung nach Anspruch 1,
bei welchem vor Erzeugung der Pfeiler (8, 9) Kontaktlöcher in die erste isolierende Schicht (15) oder eine Teilschicht dieser ersten isolierenden Schicht geätzt werden,
**dadurch gekennzeichnet**, daß
a) die Pfeiler (8, 9) durch Abscheidung eines Pfeilermaterials mindestens in den Kontaklöchern und Entfernen des Pfeilermaterials außerhalb der Kontaktlöcher mittels eines Schleifverfahrens hergestellt werden,
b) die Bitleitung (10) in der ersten isolierenden Schicht vergraben hergestellt wird, wobei ein Graben (22) in die erste isolierende Schicht (15) geätzt wird, ein Bitleitungsmaterial abgeschieden und in einem CMP-Schritt außerhalb des Grabens (22) wieder entfernt wird, und
c) die Bitleitung (10) an ihrer Oberfläche mit einem isolierenden Deckel (25) versehen wird, dessen Oberkante in etwa auf gleicher Höhe wie die Oberkante der ersten isolierenden Schicht (15) liegt, wobei
d) das Schleifverfahren so durchgeführt wird, daß die Oberkanten vorgegebener Pfeiler in einer global planarisierten Fläche liegen.

7. Herstellverfahren für eine Halbleiterspeicheranordnung nach Anspruch 1,
bei welchen die Bitleitung (10) durch ganzflächige Abscheidung eines Bitleitungsmaterials und Strukturierung mit Hilfe einer Fototechnik hergestellt wird und vor Erzeugung der Pfeiler (8, 9) Kontaktlöcher in die Planarisierungsschicht (15 c) oder eine Teilschicht einer ersten isolierenden Schicht (15) geätzt werden,
**dadurch gekennzeichnet**, daß
a) vor Abscheidung des Bitleitungsmaterials zunächst ein unterer TK-Pfeiler (9a) hergestellt wird, der niedriger ist als der TB-Pfeiler und dessen Oberfläche mit einem nichtleitenden Material bedeckt wird,
b) die Pfeiler (8, 9) durch Abscheidung eines Pfeilermaterials mindestens in den Kontaktlöchern und Entfernen des Pfeilermaterials außerhalb der Kontaktlöcher in einem CMP-Schritt hergestellt werden,
c) nach Herstellung der Bitleitung eine Planarisierungsschicht (15c) hergestellt wird
d) ein Kontaktloch in die Planarisierungsschicht (15c) und das nichtleitende Material (15b) geätzt wird, welches den unteren TK-Pfeiler (9a) mindestens teilweise freilegt, und ein oberer TK-Pfeiler (9b) durch Abscheiden eines Pfeilermaterials mindestens in diesem Kontaktloch und Entfernen des Pfeilermaterials außerhalb des Kontaktlochs in einem CMP-Schritt hergestellt wird.

8. Verfahren nach Anspruch 6,
**dadurch gekennzeichnet**, daß
die erste isolierende Schicht (15) aus einer unteren (15a) und einer oberen (15b) Teilschicht aufgebaut wird und die Pfeiler (8, 9) folgendermaßen hergestellt werden:
- Abscheidung der unteren Teilschicht (15a) und Herstellung des TB-Pfeilers in der unteren Teilschicht,
- Abscheidung der oberen Teilschicht (15b) und Herstellung des TK-Pfeilers (9) in der unteren und oberen Teilschicht.

9. Verfahren nach Anspruch 6,
**gekennzeichnet durch** die gleichzeitige Herstellung des TB-Pfeilers (8) und TK-Pfeilers (9) in der ersten isolierenden Schicht (15) und anschließendes Rückätzen des TK-Pfeilers (9) unter die Oberkante der ersten isolierenden Schicht (15).

10. Verfahren nach einem der Ansprüche 6 und 7,
**dadurch gekennzeichnet, daß**
die erste isolierende Schicht (15) aus einer unteren (15a) und einer oberen (15b) Teilschicht aufgebaut, der TB-Pfeiler (8) und ein unterer TK-Pfeiler (9a) folgendermaßen hergestellt werden:
- Abscheiden der unteren Teilschicht (15a) und Herstellung des TB-Pfeilers (8) und unteren TK-Pfeilers (9a) in der unteren Teilschicht (15a)
- Abscheiden der oberen Teilschicht (15b),
und in einem späteren Verfahrensschritt ein oberer TK-Pfeiler (9b) mindestens in der oberen Teilschicht (15b) erzeugt wird.

11. Verfahren nach einem der Ansprüche 6 bis 10 ,
**dadurch gekennzeichnet, daß**
vor Abscheiden des Bitleitungsmaterials eine Haft- und/oder Kontaktschicht (24) aufgebracht wird.

12. Verfahren nach einem der Ansprüche 6, 8 bis 11,
**dadurch gekennzeichnet, daß**
das Bitleitungsmaterial in einer mindestens der Grabenhöhe (22) entsprechenden Dicke abgeschieden wird und nach dem CMP-Schritt zur Erzeugung der Bitleitung unter die Grabenoberkante selektiv zum TK-Pfeiler (9) zurückgeätzt wird.

13. Verfahren nach einem der Ansprüche 11 bis 12,
**dadurch gekennzeichnet, daß**
der CMP-Schritt zur Erzeugung der Bitleitung selektiv zur Haft- und/oder Kontaktschicht (24) durchgeführt wird, dann das verbleibende Bitleitungsmaterial unter die Grabenoberkante selektiv zur Haft- und/oder Kontaktschicht (24) zurückgeätzt wird, die Haft- und/oder Kontaktschicht (24) entfernt und der Deckel (25) hergestellt wird.

14. Verfahren nach einem der Ansprüche 6, 8 bis 12,
**dadurch gekennzeichnet**, daß
das Bitleitungsmaterial mit schlechter Kantenbedeckung und in geringerer Dicke als die Höhe des Grabens (22) aufgebracht, an den Wänden des Grabens (22) entfernt wird, ein Deckelmaterial (25) ganzflächig aufgebracht wird und in einem CMP-Schritt das Deckelmaterial und das Bitleitungsmaterial außerhalb des Grabens (22) entfernt werden.

15. Verfahren nach einem der Ansprüche 7, 10 bis 11,
**dadurch gekennzeichnet, daß**
die Planarisierungsschicht (15c) in einem CMP-Schritt planarisiert wird, welcher die Oberfläche der Bitleitung (10) freilegt, die Bitleitung (10) anschließend zurückgeätzt wird und mit einem Deckel (25) versehen wird.

16. Verfahren nach einem der Ansprüche 6 bis 13, 15
**dadurch gekennzeichnet, daß**
der Deckel (25) durch ganzflächige Abscheidung eines Deckelmaterials auf der Bitleitung (10) und der ersten isolierenden Schicht (15) oder Planarisierungsschicht (15c) mit anschließendem CMP-Schritt, der das Deckelmaterial außerhalb des Grabens (22) entfernt, hergestellt wird.

17. Verfahren nach Anspruch 16,
**dadurch gekennzeichnet, daß**
der Deckel (25) aus einem Material hergestellt wird, daß beim anschließenden CMP-Schritt selektiv zur ersten isolierenden Schicht (15) oder Planarisierungsschicht (15c) entfernt werden kann.

18. Verfahren nach einem der Ansprüche 6 bis 13, 15,
**gekennzeichnet durch** eine Oxidation oder Nitridation der Oberfläche der Bitleitung (10) zur Erzeugung des Deckels (25).

19. Verfahren nach einem der Ansprüche 6, 8 bis 14, 16 bis 18, **dadurch gekennzeichnet, daß**
nach Ätzen des Grabens (22) eine Flankenisolation (23) an den Grabenwänden erzeugt wird.

20. Verfahren nach einem der Ansprüche 6 bis 19,
**dadurch gekennzeichnet, daß**
nach Herstellen des Deckels (25) der TK-Pfeiler (9) selektiv zur ersten isolierenden Schicht (15) und zum Deckel (25) bis unter den Boden des Grabens (22) zurückgeätzt wird, an den freiliegenden Wänden nichtleitende Spacer erzeugt werden und das verbleibende Loch mit einem Pfeilermaterial aufgefüllt wird.

21. Verfahren nach Anspruch 19,
**dadurch gekennzeichnet**, daß
die Flankenisolation (23) durch eine Oxidation oder Nitridation der seitlichen Oberfläche des an der Grabenwand freiliegenden TK-Pfeilers (9) hergestellt wird.

22. Verfahren nach einem der Ansprüche 6, 8 bis 21,
**dadurch gekennzeichnet**, daß
der CMP-Schritt zur Erzeugung der Bitleitung und/oder das Zurückätzen der Bitleitung (10) unter die Grabenoberkante selektiv zu einem auf der Oberfläche des TK-Pfeilers (9) gebildeten Oxid oder Nitrid durchgeführt wird.

23. Verfahren nach einem der Ansprüche 6, 8, 10 bis 22,
**dadurch gekennzeichnet**, daß
die Bitleitung (10) über ein Bitleitungskontaktloch (27) an den TB-Pfeiler (8) angeschlossen wird.

24. Verfahren nach Anspruch 23,
**dadurch gekennzeichnet**, daß
das Bitleitungskontaktloch (27) gemeinsam mit dem Graben (22) mit dem Bitleitungsmaterial (10) aufgefüllt wird.

25. Verfahren nach einem der Ansprüche 6, 10 bis 22,
**dadurch gekennzeichnet**, daß
der TK-Pfeiler (9) selbstjustiert zur Bitleitung (10) hergestellt wird.

26. Verfahren nach Anspruch 25,
**gekennzeichnet durch** folgende Verfahrensschritte:
- Herstellung eines TB-Pfeilers (8) und eines unteren TK-Pfeilers (9a) derart, daß der TB-Pfeiler (8) gleich hoch oder höher ist als der untere TK-Pfeiler (9a),
- Ätzen des Grabens (22) und Herstellen der Bitleitung (10),
- Herstellen eines oberen TK-Pfeilers (9b).

27. Verfahren nach einem der Ansprüche 7, 15 bis 18, 20, 21,
**dadurch gekennzeichnet, daß**
das Kontaktloch für den oberen TK-Pfeiler (9b) selektiv zur Bitleitung (10) geätzt wird und an den Innenwänden dieses Kontaktlochs eine Flankenisolation erzeugt wird.

28. Verfahren nach einem der Ansprüche 7, 15 bis 18, 20,
**dadurch gekennzeichnet**, daß
nach Abscheiden des Bitleitungsmaterials ein Deckelmaterial (25) und eine Ätzstopschicht (35) abgeschieden und gemeinsam mit der Bitleitung strukturiert werden, das Kontaktloch für den oberen TK-Pfeiler (9b) selektiv zur Ätzstoppschicht (35) in die Planarisierungsschicht (15c) geätzt wird, an den Innenwänden dieses Kontaktlochs nichtleitende Spacer erzeugt werden, und der CMP-Schritt zur Erzeugung des oberen TK Pfeilers (9b) in mehreren Teilschritten durchgeführt wird, wobei der erste Teilschritt entweder selektiv zur Ätzstopschicht (35) oder selektiv zum Deckelmaterial (25) durchgeführt wird.

29. Verfahren nach einem der Ansprüche 6 bis 28,
**dadurch gekennzeichnet**, daß
die Pfeiler (8, 9) selbstjustiert zu einem verschiedene Speicherzellen trennenden Isolationsgebiet (2) und/oder zum Gate des Transistors hersgestellt werden.

30. Verfahren nach einem der Ansprüche 6 bis 29,
**dadurch gekennzeichnet**, daß gleichzeitig mit den TB-Pfeilern (8) weitere Pfeiler (13, 14) hergestellt werden, die das Halbleitersubstrat (1) oder andere tiefer als die Bitleitungsebene liegende leitende Strukturen mit weiteren in der Bitleitungsebene liegenden Leitbahnen (12) verbinden.

31. Verfahren nach einem der Ansprüche 6 bis 30,
**dadurch gekennzeichnet**, daß
die Oberkanten der unteren Kondensatorelektroden (11) in einem CMP-Schritt mit im wesentlichen gleicher Höhe hergestellt werden.

32. Verfahren nach Anspruch 31,
**dadurch gekennzeichnet**, daß
die untere Kondensatorelektrode (11) in einem Loch (43) in einer Hilfsschicht (41) hergestellt wird, nachdem das Loch (43) durch eine isotrope Ätzung der Hilfsschicht vergrößert wurde.

33. Verfahren nach einem der Ansprüche 6 bis 32,
**dadurch gekennzeichnet**, daß
nach Herstellung des Kondensators (11, 47, 16) die Oberfläche der Halbleiterspeicheranordnung mit Hilfe eine CMP-Schrittes global planarisiert wird.

34. Verfahren nach Anspruch 33,
**gekennzeichnet durch** eine globale Planarisierung mit folgenden Verfahrens schritten:
- ganzflächiges Abscheiden eines ersten Dielektrikums (50) in einer Dicke, die der Höhe der Kondensatoren (11, 47, 16) entspricht,
- Entfernen des ersten Dielektrikums (50) im Zellenfeld mit Hilfe einer Fototechnik, wobei nur in einem Randbereich des Zellenfeldes das erste Dielektrikum (50) als Steg (50a) verbleibt,
- ganzflächige Abscheidung eines zweiten Dielektrikums (51)
- Einebnen der gesamten Oberfläche durch einen CMP-Schritt.

## Claims

1. Semiconductor memory arrangement comprising single-transistor memory cells, in which each memory cell comprises
- a transistor (3, 4, 6) arranged in or on a semiconductor substrate (1),
- a bit line (10) arranged above the transistor and a capacitor (11, 47, 48) arranged above the bit line,
- a transistor/capacitor pillar (9) (TC pillar) for electrically connecting a first S/D region (3) of the transistor to a lower capacitor plate (11) arranged on a first insulating layer (15) or planarisation layer (15c), and
- a transistor bit-line pillar (8) (TB pillar) for electrically connecting a second S/D region (4) to the bit line (10),
a) the tops of the TB pillars (8) of different memory cells being situated in a planarised surface and
b) the tops of insulating covers (25) arranged on the bit lines (10) of the first insulating layer (15) or planarisation layer (15c) and of the TC pillar (9) being situated in a further planar surface,
characterised
in that there are provided in the bit line level further conductor tracks (12) which are electrically connected to the semiconductor substrate (1) via a substrate pillar (13) (SB pillar),
in that there are provided in the bit line level further conductor tracks (12) which are electrically connected via a word-line pillar (14) (WB pillar) to further underlying conductor tracks (7) which are arranged in the word-line level,
in that the tops of the TB, SB and WB pillars (8, 13, 14) are polished and situated in the planarised surface of the top of the TB pillars, this surface being completely planarised, and
in that the further planar surface is completely planar within the limits of process fluctuations.

2. Semiconductor memory arrangement according to Claim 1, characterised by an edge insulation (23) which insulates the bit line (10) from part of the TC pillar (9).

3. Semiconductor memory arrangement according to one of Claims 1 to 2, characterised by a bit-line contact hole (27) via which the bit line (10) is connected to the TB pillar (8).

4. Semiconductor memory arrangement according to one of Claims 1 to 3, characterised in that the tops of the lower capacitor plates (11) are polished and are situated in a completely planarised surface.

5. Semiconductor memory arrangement according to one of Claims 1 to 4, characterised in that the tops of the cell arrays (Z) and the peripheral regions (P) are polished and are situated in a completely planarised surface.

6. Manufacturing process for a semiconductor memory arrangement according to Claim 1,
in which process, prior to creating the pillars (8, 9), contact holes are etched in the first insulating layer (15) or a sublayer of said first insulating layer,
characterised in that
a) the pillars (8, 9) are manufactured by depositing a pillar material at least in the contact holes and removing the pillar material outside the contact holes by means of a polishing process,
b) the bit line (10) is manufactured in buried form in the first insulating layer, a trench (22) being etched in the first insulating layer (15), and a bit-line material being deposited and removed again outside the trench (22) in a CMP step, and
c) the bit line (10) being provided at its surface with an insulating cover (25) whose top is situated approximately at the same height as the top of the first insulating layer (15),
d) the polishing process being carried out in such a manner that the tops of predetermined pillars are situated in a completely planarised surface.

7. Manufacturing process for a semiconductor memory arrangement according to Claim 1,
in which process the bit line (10) is manufactured by depositing a bit-line material over the entire surface and patterning it with the aid of a photolithographic procedure and, prior to the creation of the pillars (8, 9), contact holes are etched in the planarisation layer (15c) or in a sublayer of a first insulating layer (15), characterised in that
a) prior to deposition of the bit-line material, a lower TC pillar (9a) is first manufactured which is lower than the TB pillar and whose surface is covered with a nonconducting material,
b) the pillars (8, 9) are manufactured by depositing a pillar material at least in the contact holes and removing the pillar material outside the contact holes in a CMP step,
c) after manufacturing the bit line, a planarisation layer (15c) is manufactured,
d) a contact hole is etched in the planarisation layer (15c) and the nonconducting material (15b) which at least partially lays bare the lower TC pillar (9a) and an upper TC pillar (9b) is manufactured by depositing a pillar material at least in said contact hole and removing the pillar material outside the contact hole in a CMP step.

8. Process according to Claim 6, characterised in that the first insulating layer (15) is made up of a lower (15a) and an upper (15b) sublayer and the pillars (8, 9) are manufactured in the following way:
- deposition of the lower sublayer (15a) and manufacture of the TB pillar in the lower sublayer,
- deposition of the upper sublayer (15b) and manufacture of the TC pillar (9) in the lower and upper sublayer.

9. Process according to Claim 6, characterised by the simultaneous manufacture of the TB pillar (8) and TC pillar (9) in the first insulating layer (15) and subsequent back-etching of the TC pillar (9) below the top of the first insulating layer (15).

10. Process according to one of Claims 6 to 7, characterised in that the first insulating layer (15) is made up of a lower (15a) and an upper (15b) sublayer, the TB pillar (8) and a lower TC pillar (9a) being manufactured in the following way:
- deposition of the lower sublayer (15a) and manufacture of the TB pillar (8) and lower TC pillar (9a) in the lower sublayer (15a)
- deposition of the upper sublayer (15b),
and an upper TC pillar (9b) is created in a later process step at least in the upper sublayer (15b).

11. Process according to one of Claims 6 to 10, characterised in that, prior to deposition of the bit-line material, an adhesion and/or contact layer (24) is applied.

12. Process according to one of Claims 6, 8 to 11, characterised in that the bit-line material is deposited in a thickness corresponding at least to the trench height (22) and, after the CMP step for creating the bit line, it is back-etched below the trench top selectively with respect to the TC pillar (9).

13. Process according to one of Claims 11 to 12, characterised in that the CMP step for creating the bit line is carried out selectively with respect to the adhesion and/or contact layer (24), then the remaining bit-line material is back-etched below the trench top selectively with respect to the adhesion and/or contact layer (24), the adhesion and/or contact layer (24) is removed and the cover (25) is manufactured.

14. Process according to one of Claims 6, 8 to 12, characterised in that the bit-line material is applied with poor edge coverage and in a thickness less than the height of the trench (22) and is removed at the walls of the trench (22), a cover material (25) is applied over the entire surface, and the cover material and the bit-line material outside the trench (22) are removed in a CMP step.

15. Process according to one of Claims 7, 10 to 11,
characterised in that the planarisation layer (15c) is planarised in a CMP step which lays bare the surface of the bit line (10) , and the bit line (10) is then back-etched and provided with a cover (25).

16. Process according to one of Claims 6 to 13, 15, characterised in that the cover (25) is manufactured by deposition over the entire surface of a cover material on the bit line (10) and the first insulating layer (15) or planarisation layer (15c) followed by a CMP step which removes the cover material outside the trench (22).

17. Process according to Claim 16, characterised in that the cover (25) is manufactured from a material which can be removed selectively with respect to the first insulating layer (15) or planarisation layer (15c) in the subsequent CMP step.

18. Process according to one of Claims 6 to 13, 15, characterised by an oxidation or nitriding of the surface of the bit line (10) to create the cover (25).

19. Process according to one of Claims 6, 8 to 14, 16 to 18, characterised in that, after etching the trench (22), an edge insulation (23) is created at the trench walls.

20. Process according to one of Claims 6 to 19, characterised in that, after manufacturing the cover (25), the TC pillar (9) is back-etched selectively with respect to the first insulating layer (15) and to the cover (25) to below the base of the trench (22), nonconducting spacers are created at the exposed walls and the remaining hole is filled with a pillar material.

21. Process according to Claim 19, characterised in that the edge insulation (23) is manufactured by an oxidation or nitriding of the lateral surface of the TC pillar (9) exposed at the trench wall.

22. Process according to one of Claims 6, 8 to 21, characterised in that the CMP step for creating the bit line and/or the back-etching of the bit line (10) below the trench top is carried out selectively with respect to an oxide or nitride formed on the surface of the TC pillar (9).

23. Process according to one of Claims 6, 8, 10 to 22, characterised in that the bit line (10) is connected to the TB pillar (8) via a bit-line contact hole (27).

24. Process according to Claim 23, characterised in that the bit-line contact hole (27) is filled with the bit-line material (10) together with the trench (22).

25. Process according to one of Claims 6, 10 to 22, characterised in that the TC pillar (9) is manufactured in a self-adjusted manner with respect to the bit line (10) .

26. Process according to Claim 25, characterised by the following process steps:
- manufacture of a TB pillar (8) and a lower TC pillar (9a) in such a way that the TB pillar (8) is equally as high as, or higher than, the lower TC pillar (9a),
- etching of the trench (22) and manufacture of the bit line (10),
- manufacture of an upper TC pillar (9b).

27. Process according to one of Claims 7, 15 to 18, 20, 21, characterised in that the contact hole for the upper TC pillar (9b) is etched selectively with respect to the bit line (10) and an edge insulation is created at the inner walls of said contact hole.

28. Process according to one of Claims 7, 15 to 18, 20, characterised in that, after deposition of the bit-line material, a cover material (25) and an etch-stop layer (35) are deposited and are patterned together with the bit line, the contact hole for the upper TC pillar (9b) is etched in the planarisation layer (15c) selectively with respect to the etch-stop layer (35), nonconducting spacers are created at the inner walls of said contact hole, and the CMP step to create the upper TC pillar (9b) is carried out in a plurality of substeps, the first substep being carried out either selectively with respect to the etch-stop layer (35) or selectively with respect to the cover material (25).

29. Process according to one of Claims 6 to 28, characterised in that the pillars (8, 9) are manufactured in a self-aligned manner with respect to an insulation region (2) isolating various memory cells and/or to the gate of the transistor.

30. Process according to one of Claims 6 to 29, characterised in that further pillars (13, 14) which connect the semiconductor substrate (1) or other conducting structures situated more deeply than the bit-line level to further conductor tracks (12) in the bit-line level are manufactured at the same time as the TC pillars (8).

31. Process according to one of Claims 6 to 30, characterised in that the tops of the lower capacitor electrodes (11) are manufactured in a CMP step with essentially the same height.

32. Process according to Claim 31, characterised in that the lower capacitor electrodes (11) are manufactured in a hole (43) in an auxiliary layer (41) after the hole (43) has been enlarged by an isotropic etching of the auxiliary layer.

33. Process according to one of Claims 6 to 32, characterised in that, after manufacturing the capacitor (11, 47, 16), the surface of the semiconductor memory arrangement is completely planarised with the aid of a CMP step.

34. Process according to Claim 33, characterised by a complete planarisation comprising the following process steps:
- deposition over the entire surface of a first dielectric (50) in a thickness which corresponds to the height of the capacitors (11, 47, 16),
- removal of the first dielectric (50) in the cell array with the aid of a photolithographic procedure, the first dielectric (50) being left behind as a ridge (50a) only in a peripheral region,
- deposition over the entire surface of a second dielectric (51),
- levelling of the entire surface by a CMP step.

## Revendications

1. Mémoire à semi-conducteurs avec des cellules de mémoire à un transistor, chaque cellule de mémoire comportant
- un transistor (3, 4, 6) disposé dans un substrat semi-conducteur (1),
- une ligne de bit (10) disposée au-dessus du transistor et un condensateur (11, 47, 48) disposé au-dessus de la ligne de bit,
- un pilier transistor-condensateur (9) (pilier TK), pour la liaison électrique d'une première zone de source ou de drain (3) (zone S/D) du transistor avec une plaque inférieure (11) de condensateur disposée sur une première couche isolante (15) ou couche de planarisation (15c) et
- un pilier transistor-ligne de bit (8) (pilier TB), pour la liaison électrique d'une deuxième zone S/D (4) avec la ligne de bit (10),
a) les bords supérieurs des piliers TB (8) de diverses cellules de mémoire se trouvant dans une surface planarisée et
b) les bords supérieurs des couvercles isolants (25) disposés sur les lignes de bit (10), de la première couche isolante (15) ou de la couche de planarisation (15c) et des piliers TK (9) se trouvant dans une autre surface planaire,
**caractérisé par le fait**
que d'autres pistes conductrices (12) sont prévues dans le plan de la ligne de bit, lesquelles sont reliées électriquement, par l'intermédiaire d'un pilier en substrat (13) (pilier SB), au substrat semi-conducteur (1),
que d'autres pistes conductrices (12) sont prévues dans le plan de la ligne de bit, lesquelles sont reliées électriquement, par l'intermédiaire d'un pilier de ligne de mot (14) (pilier WB), à d'autres pistes conductrices (7) plus profondes qui sont disposées dans le plan de la ligne de mot,
que les bords supérieurs des piliers TB, SB et WB (8, 13, 14) sont polis et se trouvent dans la surface planarisée du bord supérieur des piliers TB, cette surface étant planarisée globalement, et
que le reste de la surface planaire est globalement planaire dans le cadre des fluctuations du processus.

2. Mémoire à semi-conducteurs selon la revendication 1 **caractérisée par** une isolation de flancs (23), qui isole la ligne de bit (10) par rapport à une partie du pilier TK (9).

3. Mémoire à semi-conducteurs selon l'une des revendications 1 à 2 **caractérisée par** un trou de contact (27) de ligne de bit à travers lequel la ligne de bit (10) est connectée au pilier TB (8).

4. Mémoire à semi-conducteurs selon l'une des revendications 1 à 3 **caractérisée par le fait** que les bords supérieurs des plaques inférieures de condensateurs (11) sont polies et se trouvent dans une surface globalement planarisée.

5. Mémoire à semi-conducteurs selon l'une des revendications 1 à 4 **caractérisée par le fait** que les bords supérieurs de champs de cellules (Z) et de zones périphériques (P) sont polies et se trouvent dans une surface globalement planarisée.

6. Procédé de fabrication d'une mémoire à semi-conducteurs conforme à la revendication 1
au cours duquel, avant la production des piliers (8, 9), des trous de contact sont gravés dans la première couche isolante (15) ou dans une couche partielle de cette première couche isolante
**caractérisé par le fait** que
a) les piliers (8, 9) sont fabriqués par précipitation d'un matériau de pilier au moins dans les trous de contact et élimination du matériau de pilier à l'extérieur des trous de contact au moyen d'un procédé de polissage,
b) la ligne de bit (10) est fabriquée enfouie dans la première couche isolante, un sillon (22) étant gravé dans la première couche isolante (15), un matériau de ligne de bit étant précipité, puis éliminé à l'extérieur du sillon (22) dans une étape CMP, et
c) la ligne de bit (10) est munie sur sa surface d'un couvercle isolant (25), dont le bord supérieur se trouve à peu près à la même hauteur que le bord supérieur de la première couche isolante (15),
d) le procédé de polissage étant exécuté de telle sorte que les bords supérieurs de piliers prédéterminés se trouvent dans une surface planarisée globalement.

7. Procédé de fabrication d'une mémoire à semi-conducteurs conforme à la revendication 1
au cours duquel la ligne de bit (10) est fabriquée par précipitation sur toute la surface d'un matériau de ligne de bit et structuration à l'aide d'une technique photographique et, avant la production des piliers (8, 9), des trous de contact sont gravés dans la couche de planarisation (15c) ou dans une couche partielle d'une première couche isolante (15),
**caractérisé par le fait** que
a) avant précipitation du matériau de ligne de bit, on fabrique d'abord un pilier TK inférieur (9a), qui est plus bas que le pilier TB et dont la surface est recouverte d'un matériau non conducteur,
b) les piliers (8, 9) sont fabriqués par précipitation d'un matériau de pilier au moins dans les trous de contact, puis élimination, dans une étape CMP, du matériau de pilier à l'extérieur des trous de contact,
c) après fabrication de la ligne de bit, une couche de planarisation (15c) est fabriquée,
d) on grave, dans la couche de planarisation (15c) et le matériau non conducteur (15b), un trou de contact qui met à découvert, au moins partiellement, le pilier TK inférieur (9a) et on fabrique un pilier TK supérieur (9b) par précipitation d'un matériau de pilier au moins dans ce trou de contact, puis élimination, dans une étape CMP, du matériau de pilier à l'extérieur du trou de contact.

8. Procédé selon la revendication 6
**caractérisé par le fait**
que la première couche isolante (15) est constituée d'une couche partielle inférieure (15a) et d'une couche partielle supérieure (15b) et que les piliers (8, 9) sont fabriqués de la façon suivante:
- précipitation de la couche partielle inférieure (15a) et fabrication du pilier TB dans la couche partielle inférieure,
- précipitation de la couche partielle supérieure (15b) et fabrication du pilier TK (9) dans la couche partielle inférieure et la couche partielle supérieure.

9. Procédé selon la revendication 6
**caractérisé par** la fabrication simultanée du pilier TB (8) et du pilier TK (9) dans la première couche isolante (15), suivie d'un décapage en retrait du pilier TK (9) sous le bord supérieur de la première couche isolante (15).

10. Procédé selon l'une des revendications 6 et 7
**caractérisé par le fait**
que la première couche isolante (15), constituée d'une couche partielle inférieure (15a) et d'une couche partielle supérieure (15b), le pilier TB (8) et un pilier TK inférieur (9a) sont fabriqués de la façon suivante:
- précipitation de la couche partielle inférieure (15a) et fabrication du pilier TB (8) et du pilier TK inférieur (9a) dans la couche partielle inférieure (15a),
- précipitation de la couche partielle supérieure (15b) et que, dans une étape de procédé ultérieure, un pilier TK supérieur (9b) est produit au moins dans la couche partielle supérieure (15b).

11. Procédé selon l'une des revendications 6 à 10
**caractérisé par le fait**
que, avant précipitation du matériau de ligne de bit, une couche de contact et/ou adhésive (24) est appliquée.

12. Procédé selon l'une des revendications 6, 8 à 11
**caractérisé par le fait**
que le matériau de ligne de bit est précipité sur une épaisseur qui correspond au moins à la hauteur du sillon (22) et que, après l'étape CMP pour la production de la ligne de bit, il est décapé en retrait sous le bord supérieur du sillon, sélectivement par rapport au pilier TK (9).

13. Procédé selon l'une des revendications 11 à 12
**caractérisé par le fait**
que l'étape CMP pour la production de la ligne de bit est exécutée sélectivement par rapport à la couche de contact et/ou adhésive (24), puis le matériau de ligne de bit restant est décapé en retrait sous le bord supérieur du sillon, sélectivement par rapport à la couche de contact et/ou adhésive (24), que la couche de contact et/ou adhésive (24) est enlevée et que le couvercle (25) est fabriqué.

14. Procédé selon l'une des revendications 6, 8 à 12
**caractérisé par le fait**
que le matériau de ligne de bit, qui a été appliqué avec une mauvaise couverture des bords et sur une épaisseur moindre que la hauteur du sillon (22), est enlevé des parois du sillon (22), qu'un matériau de couvercle (25) est appliqué sur toute la surface et que, dans une étape CMP, le matériau du couvercle et le matériau de ligne de bit est éliminé à l'extérieur du sillon (22).

15. Procédé selon l'une des revendications 7, 10 à 11
**caractérisé par le fait**
que la couche de planarisation (15c) est planarisée dans une étape CMP, qui met décapée en retrait et recouverte d'un couvercle (25).

16. Procédé selon l'une des revendications 6 à 13, 15
**caractérisé par le fait**
que le couvercle (25) est fabriqué par précipitation sur toute la surface d'un matériau de couvercle sur la ligne de bit (10) et sur la première couche isolante (15) ou la couche de planarisation (15c), suivie d'une étape CMP, qui enlève le matériau de couvercle à l'extérieur du sillon (22).

17. Procédé selon la revendication 16
**caractérisé par le fait**
que le couvercle (25) est fabriqué avec un matériau qui peut, lors de l'étape CMP qui suit, être enlevé sélectivement par rapport à la première couche isolante (15) ou la couche de planarisation (15c).

18. Procédé selon l'une des revendications 6 à 13, 15
**caractérisé par** une oxydation ou nitruration de la surface de la ligne de bit (10) pour la production du couvercle (25).

19. Procédé selon l'une des revendications 6, 8 à 14, 16 à 18
**caractérisé par le fait**
que, après gravure du sillon (22), une isolation de flancs (23) est produite sur les parois du sillon.

20. Procédé selon l'une des revendications 6 à 19
**caractérisé par le fait**
que, après la fabrication du couvercle (25), le pilier TK (9) est décapé en retrait, sélectivement par rapport à la première couche isolante (15) et au couvercle (25), jusque sous le fond du sillon (22), que des spacers non conducteurs sont produits sur les parois découvertes et que le trou restant est rempli d'un matériau de pilier.

21. Procédé selon la revendication 19
**caractérisé par le fait**
que l'isolation des flancs (23) est fabriquée par une oxydation ou nitruration de la surface latérale des piliers TK (9) qui est à découvert sur la paroi du sillon.

22. Procédé selon l'une des revendications 6, 8 à 21
**caractérisé par le fait**
que l'étape CMP pour la production de la ligne de bit et/ou le décapage en retrait de la ligne de bit (10) sous le bord supérieur du sillon sont effectués sélectivement par rapport à un oxyde ou un nitrure formé sur la surface du pilier TK (9).

23. Procédé selon l'une des revendications 6, 8, 10 à 22
**caractérisé par le fait**
que la ligne de bit (10) est raccordée au pilier TB (8) par l'intermédiaire d'un trou de contact de ligne de bit (27).

24. Procédé selon la revendication 23
**caractérisé par le fait**
que le trou de contact de ligne de bit (27) est rempli de matériau de ligne de bit (10) en même temps que le sillon (22).

25. Procédé selon l'une des revendications 6, 10 à 22
**caractérisé par le fait**
que le pilier TK (9) est fabriqué avec ajustage automatique par rapport à la ligne de bit (10).

26. Procédé selon la revendication 25
**caractérisé par** les étapes de procédé suivantes:
- fabrication d'un pilier TB (8) et d'un pilier TK inférieur (9a) tels que le pilier TB (8) a la même hauteur ou est plus haut que le pilier TK inférieur (9a),
- gravure du sillon (22) et fabrication de la ligne de bit (10),
- fabrication d'un pilier TK supérieur (9b).

27. Procédé selon l'une des revendications 7, 15 à 18, 20, 21
**caractérisé par le fait**
que le trou de contact pour le pilier TK supérieur (9b) est gravé sélectivement par intérieures de ce trou de contact.

28. Procédé selon l'une des revendications 7, 15 à 18, 20
**caractérisé par le fait**
que, après précipitation du matériau de ligne de bit, on précipite un matériau de couvercle (25) et une couche d'interruption du décapage (35) et on les structure en même temps que la ligne de bit, on grave, dans la couche de planarisation (15c); le trou de contact pour le pilier TK supérieur (9b), sélectivement par rapport à la couche d'interruption du décapage (35), on produit des spacers non conducteurs sur les parois intérieures de ce trou de contact et on exécute, en plusieurs étapes partielles, l'étape CMP pour la production du pilier TK supérieur (9b), la première étape partielle étant exécutée ou bien sélectivement par rapport à la couche de stoppage du décapage (35) ou bien sélectivement par rapport au matériau de couvercle (25).

29. Procédé selon l'une des revendications 6 à 28
**caractérisé par le fait**
que les piliers (8, 9) sont fabriqués avec ajustage automatique par rapport à une zone d'isolation (2), qui sépare différentes cellules de mémoire, et/ou par rapport à la grille du transistor.

30. Procédé selon l'une des revendications 6 à 29
**caractérisé par le fait**
qu'on fabrique, en même temps que les piliers TB (8), d'autres piliers (13, 14), qui relient le substrat semi-conducteur (1) ou d'autres structures conductrices, qui se trouvent plus bas que le plan de la ligne de bit, à d'autres pistes conductrices (12) qui se trouvent dans le plan de la ligne de bit.

31. Procédé selon l'une des revendications 6 à 30
**caractérisé par le fait**
que les bords supérieurs des électrodes inférieures (11) des condensateurs sont fabriqués, en une étape CMP, avec une hauteur essentiellement identique.

32. Procédé selon la revendication 31
**caractérisé par le fait**
que l'électrode inférieure (11) du condensateur est fabriquée dans un trou (43) dans une couche auxiliaire (41), après que le trou (43) ait été agrandi grâce à une gravure isotrope de la couche auxiliaire.

33. Procédé selon l'une des revendications 6 à 32
**caractérisé par le fait**
que, après fabrication du condensateur (11, 47, 16), la surface de la mémoire à semi-conducteurs est planarisée globalement à l'aide d'une étape CMP.

34. Procédé selon la revendication 33
**caractérisé par** une planarisation globale avec les étapes de procédé suivantes:
- précipitation sur toute la surface d'un premier diélectrique (50) avec une épaisseur qui correspond à la hauteur des condensateurs (11, 47, 16),
- élimination, à l'aide d'une technique photographique, du premier diélectrique (50) dans le champ de cellules, le premier diélectrique (50) ne restant que dans une zone de bordure du champ de cellules sous forme de bride (50a),
- précipitation sur toute la surface d'un deuxième diélectrique (51),
- Aplanissement de l'ensemble de la surface grâce à une étape CMP.
